# EUROPEAN PATENT SPECIFICATION

(11) **EP 2 096 709 B1**
(45) Date of publication and mention of the grant of the patent: **25.04.2012**
(21) Application number: 08865022.1
(22) Date of filing: 08.12.2008
(51) Int. Cl.: H01Q 1/50, B42D 15/10, G06K 19/07, G06K 19/077, H01F 17/00, H01Q 1/38

(54) **RADIO IC DEVICE**
IC-RADIOGERÄT
DISPOSITIF CI RADIO

(30) Priority: 20.12.2007 JP 2007329360; 07.07.2008 JP 2008177236; 21.08.2008 JP 2008213164
(43) Date of publication of application: 02.09.2009
(60) Divisional application: 11185009.5
(73) Proprietor: MURATA MANUFACTURING CO., LTD., Nagaokakyo-shi, Kyoto 617-8555 (JP)
(72) Inventor: KATO, Noboru, Nagaokakyo-shi Kyoto 617-8555 (JP); SASAKI, Jun, Nagaokakyo-shi Kyoto 617-8555 (JP); YAMADA, Kosuke, Nagaokakyo-shi Kyoto 617-8555 (JP)
(74) Representative: Zimmermann, Tankred Klaus
(86) International application number: PCT/JP2008/072260
(87) International publication number: WO 2009/081719

(56) References cited:
- WO-A1-2007/083574
- WO-A1-2007/119310
- JP-A- 2004 336 250
- US-A1- 2007 052 613

## Description

### Technical Field

The present invention relates to wireless integrated circuit (IC) devices. More particularly, the present invention relates to a wireless IC device used in a radio frequency identification (RFID) system.

### Background Art

Hitherto, RFID systems have been developed as management systems of articles. In a typical RFID system, a reader-writer generating an induction field communicates with a wireless tag (also referred to as a wireless IC device) that is appended to an article and that stores certain information in a non-contact manner to transmit information. JP 2006-80367 proposes a wireless tag used in an RFID system of this kind. In the wireless tag proposed in JP 2006-80367, an antenna and a matching circuit are formed on a flexible substrate and an IC chip is arranged on the substrate so as to be electrically conducted to the antenna and the matching circuit. The matching circuit is provided by forming a loop coil (inductor) on the substrate.

However, the wireless tag disclosed in JP 2006-80367 has a drawback that the inductance of the loop coil can be varied depending on the permittivity of an article to which the wireless tag is appended and/or the surrounding environment of the article to vary the characteristics of the matching circuit for impedance matching between the IC chip and the antenna because the matching circuit is bare on the flexible substrate. The variation in the characteristics of the matching circuit causes a problem that a loss occurs in transmission of a signal between the IC chip and the antenna to reduce the radiation characteristics of the antenna. In addition, it is necessary to complicatedly design the antenna for every article in accordance with, for example, the permittivity of the article to which the antenna is pasted because the frequency used by the wireless tag is determined by the length of the antenna.
US 2007/052613 A1 discloses an RFID transponder having a microchip or integrated circuit, an impedance-matching structure and a resonant structure mounted on at least one substrate and connected to each other by an electric field.
It is an object of the present invention to provide a wireless IC device that is less susceptible to, for example, the environment in which the wireless IC device is used, that is capable of suppressing a variation in the radiation characteristics, and that is capable of being used in a wideband.
This object is achieved by a wireless IC device according to claim 1.

Since the resonant frequencies of signals are set in the feeder circuit in the above wireless IC devices, the wireless IC device normally operates even if the wireless IC device is mounted on various articles and a variation in the radiation characteristics is suppressed, thus eliminating the need for changing the design of the radiation strip, etc. for every article. Particularly, since the at least two inductance elements composing the feeder circuit are wound in opposite directions, the magnetic fields generated in the inductance elements are offset by each other to decrease the Q value, thus suppressing the steepness of the resonance characteristics to broaden the resonance characteristics near the resonant frequency. In addition, since the magnetic fields have opposite directions, one magnetic field directs upward when the other magnetic field directs downward. These directions correspond to the positive and negative phases of an AC power supply and almost 100% of energy can be transferred to the radiation strip via the magnetic-field energy.

The frequency of a transmission signal radiated from the radiation strip and the frequency of a reception signal supplied to the wireless IC substantially correspond to the resonant frequency of the resonant circuit, and the maximum gain of a signal is substantially determined by at least one of the size and shape of the feeder circuit and the distance and the medium between the feeder circuit and the radiation strip. Since the frequencies of the transmission and reception signals are determined in the feeder circuit board, the frequency characteristics are not varied even if, for example, the wireless IC device is rolled or is sandwiched between dielectric materials, thus achieving the stable frequency characteristics regardless of the shape, size, and arrangement of the radiation strip.

### Advantages

According to the present invention, since the feeder circuit including a resonant circuit and/or a matching circuit is provided between the wireless IC and the radiation strip, it is possible to effectively prevent the resonant frequency and the radiation characteristics from being affected by, for example, an article to which the wireless IC device is adhered. In addition, since the at least two inductance elements composing the feeder circuit are helically formed with being wound in opposite directions, the magnetic fields generated in the inductance elements are offset by each other to broaden the resonance characteristics near the resonant frequency. The provision of the feeder circuit including a resonant circuit and/or a matching circuit that includes at least two inductance elements on the main face of the wireless IC where the input-output terminal electrodes are formed eliminates the need to provide the feeder circuit board, thus reducing the size and height of the wireless IC device.

### Brief Description of Drawings

[Fig. 1] Fig. 1 is an equivalent circuit diagram showing a feeder circuit composing a wireless IC device of a first embodiment.
[Fig. 2] Fig. 2 includes diagrams showing a radiation strip composing the wireless IC device of the first embodiment: Fig. 2(A) is a plan view and Fig. 2(B) is a plan view showing a state where a feeder circuit board is adhered.
[Fig. 3] Fig. 3 is a perspective view showing a state where a wireless IC chip is mounted on the feeder circuit board composing the wireless IC device of the first embodiment.
[Fig. 4] Fig. 4 includes plan views showing a layering structure of the feeder circuit board of the wireless IC device of the first embodiment.
[Fig. 5] Fig. 5 includes plan views showing a layering structure of a feeder circuit board of a wireless IC device of a second embodiment.
[Fig. 6] Fig. 6 is an equivalent circuit diagram of a wireless IC device of a third embodiment.
[Fig. 7] Fig. 7 includes diagrams showing a radiation strip of the wireless IC device of the third embodiment: Fig. 3(A) is a plan view, Fig. 3(B) is a rear view, and Fig. 3(C) is a plan view of a magnetic body provided on the rear face.
[Fig. 8] Fig. 8 includes plan views showing a layering structure of a feeder circuit board of the wireless IC device of the third embodiment.
[Fig. 9] Fig. 9 is a perspective view of a wireless IC device of a fourth embodiment.
[Fig. 10] Fig. 10 includes plan views showing a layering structure of a feeder circuit board of the wireless IC device of the fourth embodiment.
[Fig. 11] Fig. 11 includes plan views showing a layering structure of a feeder circuit board of a wireless IC device of a fifth embodiment.
[Fig. 12] Fig. 12 includes perspective views showing a layering structure of a feeder circuit board of a wireless IC device of a sixth embodiment.
[Fig. 13] Fig. 13 includes perspective views showing a layering structure of a feeder circuit board of a wireless IC device of a seventh embodiment.
[Fig. 14] Fig. 14 includes perspective views showing a layering structure of a feeder circuit board of a wireless IC device of an eighth embodiment.
[Fig. 15] Fig. 15 is an equivalent circuit diagram of the feeder circuit board shown in Fig. 14.
[Fig. 16] Fig. 16 includes perspective views showing another layering structure of the feeder circuit board of the wireless IC device of the eighth embodiment.
[Fig. 17] Fig. 17 is an equivalent circuit diagram of the feeder circuit board shown in Fig. 16.
[Fig. 18] Fig. 18 is a perspective view showing a wireless IC device of a ninth embodiment.
[Fig. 19] Fig. 19 is a perspective view showing a state where the wireless IC device of the ninth embodiment is mounted on a metal can.
[Fig. 20] Fig. 20 is a partially enlarged cross-sectional view of Fig. 19.
[Fig. 21] Fig. 21 is an equivalent circuit diagram showing a feeder circuit composing a wireless IC device of a tenth embodiment.
[Fig. 22] Fig. 22 includes diagrams illustrating a manufacturing process of a feeder circuit board of the wireless IC device of the tenth embodiment.
[Fig. 23] Fig. 23 includes rear views showing intermediate states of the manufacturing process shown in Fig. 22.
[Fig. 24] Fig. 24 is an equivalent circuit diagram showing a feeder circuit composing a wireless IC device of an eleventh embodiment.
[Fig. 25] Fig. 25 includes diagrams illustrating a manufacturing process of a feeder circuit board of the wireless IC device of the eleventh embodiment.
[Fig. 26] Fig. 26 includes rear views showing intermediate states of the manufacturing process shown in Fig. 25.
[Fig. 27] Fig. 27(A) is an equivalent circuit diagram showing a feeder circuit of a wireless IC device of a twelfth embodiment and Fig. 27(B) is an equivalent circuit diagram showing a feeder circuit of a wireless IC device of a thirteenth embodiment.
[Fig. 28] Fig. 28 (A) is an equivalent circuit diagram showing a feeder circuit of a wireless IC device of a fourteenth embodiment and Fig. 28(B) is an equivalent circuit diagram showing a feeder circuit of a wireless IC device of a fifteenth embodiment.
[Fig. 29] Fig. 29 includes diagrams showing wireless IC devices from the twelfth embodiment to the fifteenth embodiment: Fig. 29(A) is a front view, Fig. 29(B) is a plan view, and Fig. 29(C) and Fig. 29(D) are rear views.
[Fig. 30] Fig. 30 includes plan views showing a layering structure of a feeder circuit board of each of the wireless IC devices from the twelfth embodiment to the fifteenth embodiment.
[Fig. 31] Fig. 31 includes diagrams showing the wireless IC device from the twelfth embodiment to the fifteenth embodiment: Fig. 31(A) is a plan view in a state where the feeder circuit board is mounted on a radiation strip, Fig. 31(B) is a plan view showing a first example of the radiation strip, Fig. 31(C) is a plan view showing a second example of the radiation strip, and Fig. 31(D) is a rear view of the radiation strip.

### Reference Numerals

L1 to L4 inductance element
10 wireless IC chip
20, 220 feeder circuit board
21, 150, 200 feeder circuit
30, 50, 130, 210 radiation substrate
32, 52, 132, 212 radiation strip
33 magnetic body
46a, 46b wiring electrode
49a, 49b magnetic body
66a to 66d wiring electrode
75a, 75b wiring electrode
85a, 85b wiring electrode
88a, 88b magnetic body
101a, 101b wiring electrode
111a, 111b wiring electrode
112a, 112b magnetic body
125a, 125b wiring electrode
128a, 128b magnetic body
129 auxiliary matching circuit
133 auxiliary electrode
204a, 204b wiring electrode

### Best Modes for Carrying Out the Invention

Embodiments of a wireless IC device according to the present invention will herein be described with reference to the attached drawings.

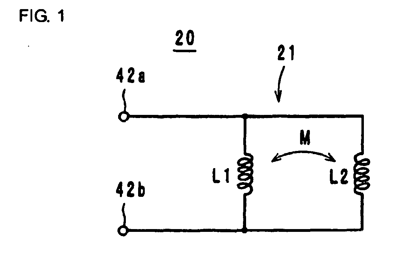

### (First Embodiment, refer to Figs. 1 to 4)

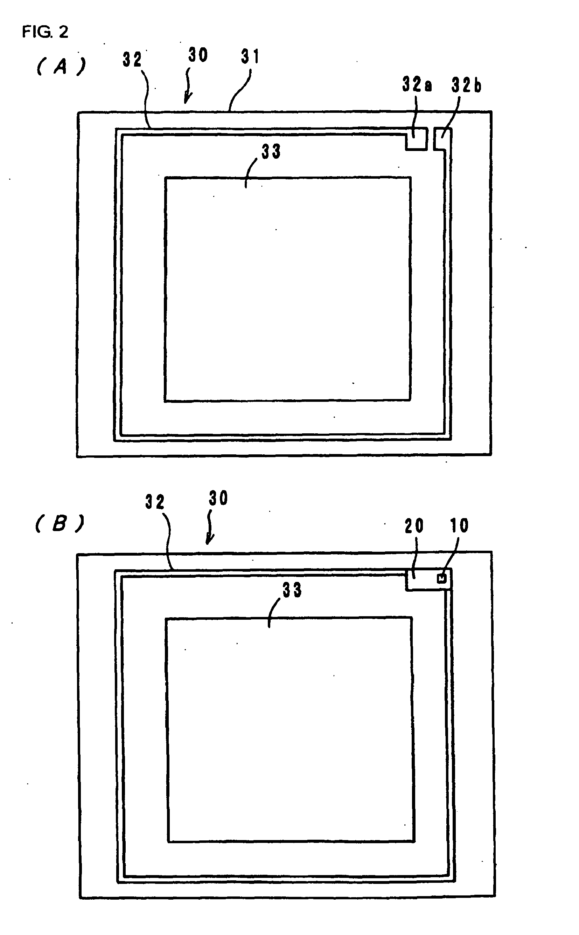

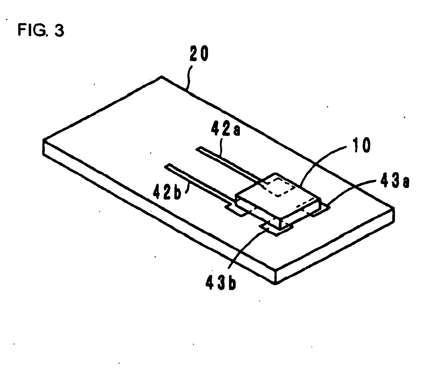

A wireless IC device of a first embodiment includes a wireless IC chip 10 processing transmission and reception signals having predetermined frequencies and a feeder circuit board 20 on which the wireless IC chip 10 is mounted, which are shown in Fig. 3. The wireless IC device of the first embodiment also includes a radiation substrate 30 shown in Fig. 2(A) or Fig. 2(B).

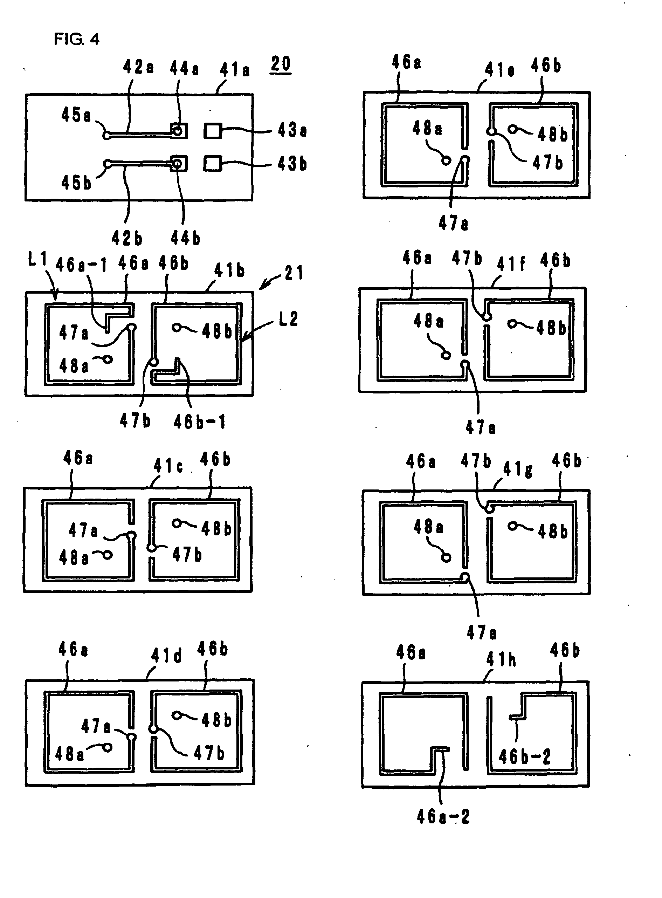

As shown in Fig. 1 as an equivalent circuit, the feeder circuit board 20 includes a feeder circuit 21 (described in detail below with reference to Fig. 4) that includes a resonant circuit and/or a matching circuit including inductance elements L1 and L2. The inductance of the inductance element L1 is different from that of the inductance element L2 and the inductance element L1 is out of phase with and magnetically coupled to the inductance element L2 (indicated by a mutual inductance M).

The wireless IC chip 10 includes a clock circuit, a logic circuit, a memory circuit, and so on. Necessary information is stored in the wireless IC chip 10. A pair of input-output terminal electrodes and a pair of mounting terminal electrodes, which are not shown in the drawings, are provided on the rear face of the wireless IC chip 10. As shown in Fig. 3, the input-output terminal electrodes are electrically connected to feeder terminal electrodes 42a and 42b formed on the feeder circuit board 20 via metal bumps or the likes, and the mounting terminal electrodes are electrically connected to mounting electrodes 43a and 43b formed on the feeder circuit board 20 via metal bumps or the likes.

On the radiation substrate 30, as shown in Fig. 2, a loop radiation strip 32 made of a nonmagnetic metal material is formed along the periphery on a flexible resin film base 31. The feeder circuit board 20 is adhered to one end 32a of the radiation strip 32 and the other end 32b thereof via adhesive. The ends 32a and 32b are each coupled to either of the inductance elements L1 and L2 in the feeder circuit 21. A magnetic body 33 is arranged inside the loop of the radiation strip 32. Fig. 2(B) shows a state where the feeder circuit board 20 on which the wireless IC chip 10 is mounted is adhered on the radiation strip 32 on the radiation substrate 30.

The inductance elements L1 and L2 included in the feeder circuit 21 are out of phase with and magnetically coupled to each other to resonate with the frequency processed by the wireless IC chip 10 and to be electromagnetically coupled to the ends 32a and 32b of the radiation strip 32. The feeder circuit 21 matches the impedance (normally 50Ω) of the wireless IC chip 10 with the impedance (a spatial impedance of 377Ω) of the radiation strip 32.

Accordingly, the feeder circuit 21 supplies a transmission signal that is sent from the wireless IC chip 10 and that has a predetermined frequency to the radiation strip 32 and selects a reception signal having a predetermined frequency from the signals received by the radiation strip 32 to supply the selected signal to the wireless IC chip 10. As a result, in this wireless IC device, the wireless IG chip 10 operates in response to the signal received by the radiation strip 32 and a response signal from the wireless IC chip 10 is externally radiated from the radiation strip 32.

As described above, since the resonant frequency of a signal is set in the feeder circuit 21 provided on the feeder circuit board 20 in the wireless IC device, the wireless IC device normally operates even if the wireless IC device is mounted on various articles and a variation in the radiation characteristics is suppressed, thus eliminating the need for changing the design of the radiation strip 32, etc. for every article. The frequency of a transmission signal radiated from the radiation strip 32 and the frequency of a reception signal supplied to the wireless IC chip 10 substantially correspond to the resonant frequency of the feeder circuit 21 on the feeder circuit board 20. The maximum gain of a signal is substantially determined by at least one of the size and shape of the feeder circuit 21 and the distance and the medium between the feeder circuit and the radiation strip. Since the frequencies of the transmission and reception signals are determined by the feeder circuit board 20, the frequency characteristics are not varied even if, for example, the wireless IC device is rolled or is sandwiched between dielectric materials, thus achieving the stable frequency characteristics regardless of the shape, size, and arrangement of the radiation strip 32.

The structure of the feeder circuit board 20 will now be described with reference to Fig. 4. The feeder circuit board 20 is manufactured by layering, attaching by pressure, and firing ceramic sheets 41a to 41h made of a dielectric material or a magnetic material. Feeder terminal electrodes 42a and 42b, mounting electrodes 43a and 43b, and via-hole conductors 44a, 44b, 45a, and 45b are formed on the top-layer sheet 41a. Wiring electrodes 46a and 46b composing the inductance elements L1 and L2, respectively, are formed on the respective layers from the second-layer sheet 41b to the eighth-layer sheet 41h. Via-hole conductors 47a, 47b, 48a, and 48b are formed on the layers from the second-layer sheet 41b to the eighth-layer sheet 41h, if needed.

Layering the above sheets 41a to 41h forms the inductance element L1 in which the wiring electrodes 46a are helically connected to each other via the via-hole conductor 47a and forms the inductance element L2 in which the wiring electrodes 46b are helically connected to each other via the via-hole conductor 47b. A capacitance is generated between the lines of the wiring electrodes 46a and 46b.

An end 46a-1 of the wiring electrode 46a on the sheet 41b is connected to the feeder terminal electrode 42a via the via-hole conductor 45a, and an end 46a-2 of the wiring electrode 46a on the sheet 41h is connected to the feeder terminal electrode 42b via the via-hole conductors 48a and 45b. An end 46b-1 of the wiring electrode 46b on the sheet 41b is connected to the feeder terminal electrode 42b via the via-hole conductor 44b, and an end 46b-2 of the wiring electrode 46b on the sheet 41h is connected to the feeder terminal electrode 42a via the via-hole conductors 48b and 44a.

Since the inductance elements L1 and L2 are wound in opposite directions around the winding axes that are substantially parallel to each other in the above feeder circuit 21, the magnetic field generated in the inductance element L1 is offset by the magnetic field generated in the inductance element L2. It is necessary to increase the lengths of the wiring electrodes 46a and 46b to some extent in order to generate a desired inductance because the magnetic fields are offset by each other. This reduces the Q value to suppress the steepness of the resonance characteristics, thereby broaden the resonance characteristics near the resonant frequency.

In a perspective plan view of the feeder circuit board 20, the inductance elements L1 and L2 are formed at different left-side and right-side positions. The direction of the magnetic field generated in the inductance element L1 is opposite to that of the magnetic field generated in the inductance element L2. Accordingly, when the feeder circuit 21 is coupled to the ends 32a and 32b of the loop radiation strip 32, a current excited at the end 32a flows in the direction opposite to the direction in which a current excited at the end 32b flows and, therefore, signals can be transmitted and received with the loop radiation strip 32. The inductance elements L1 and L2 may be coupled to different radiation strips.

The radiation strip 32 is composed of a loop electrode having the one end 32a and the other end 32b, and the ends 32a and 32b are coupled to the different inductance elements L1 and L2, respectively. The magnetic body 33 made of, for example, ferrite is arranged inside the loop of the loop electrode. The presence of the magnetic body 33 causes amplification of the magnetic field generated around the radiation strip 32 composed of the loop electrode to increase the communication distance. The magnetic body 33 may not necessarily be provided and may be omitted.

Since the feeder circuit board 20 is made of a magnetic material and the inductance elements L1 and L2 are formed in the magnetic body, a higher inductance is generated and the frequencies around 13.56 MHz are supported. In addition, even if a variation in manufacturing or permittivity between the sheets made of a magnetic material occurs, a variation in impedance between the magnetic sheets and the wireless IC chip 10 can be accommodated. The magnetic material preferably has a permittivity µ of around 400.

Setting the inductances of the two inductance elements L1 and L2 to substantially the same value allows the magnetic fields of the same magnitude to be generated in the inductance elements L1 and L2. Accordingly, the magnetic fields generated in the inductance elements L1 and L2 have the same amount of offset to allow the resonance characteristics near the resonant frequency to be broadened.

The feeder circuit board 20 may be a multilayer board made of ceramics or resin or may be a board in which flexible sheets made of a dielectric material, such as polyimide or liquid crystal polymer, are layered. Particularly, incorporating the inductance elements L1 and L2 in the feeder circuit board 20 causes the feeder circuit 21 to be less susceptible to the outside of the board, thereby suppressing a variation in the radiation characteristics.

The feeder circuit board 20 may not be adhered on the ends 32a and 32b of the radiation strip 32. The feeder circuit board 20 may be arranged in proximity to the ends 32a and 32b.

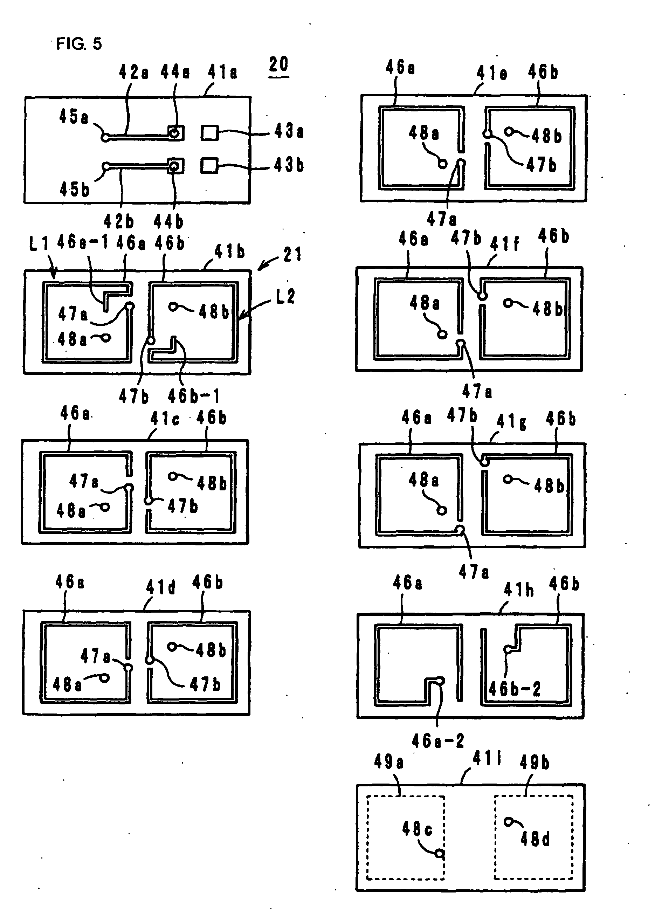

### (Second Embodiment, refer to Fig. 5)

A wireless IC device of a second embodiment basically has a structure similar to that of the first embodiment. As shown in Fig. 5, the wireless IC device of the second embodiment differs from the first embodiment in that, in a perspective plan view of the feeder circuit board 20, planer electrodes 49a and 49b are provided on the rear face of a sheet 41i that is the bottom layer of the feeder circuit board 20. The planer electrodes 49a and 49b have the same outer dimensions as those of the inductance elements L1 and L2 or have outer dimensions smaller than those of the inductance elements L1 and L2.

Via-hole conductors are arranged at the respective ends 46a-2 and 46b-2 of the wiring electrodes 46a and 46b forming the inductance elements L1 and L2. The via-hole conductors are connected to the feeder terminal electrodes 42a and 42b and are also connected to the planer electrodes 49a and 49b via via-hole conductors 48c and 48d formed in the sheet 41i. The provision of the planer electrodes 49a and 49b allows a variation in coupling between the feeder circuit 21 and the radiation strip 32 to be suppressed.

The planer electrodes 49a and 49b may not be electrically connected to the wiring electrodes 46a and 46b. The planer electrodes 49a and 49b may be electrically connected to the radiation strip 32.

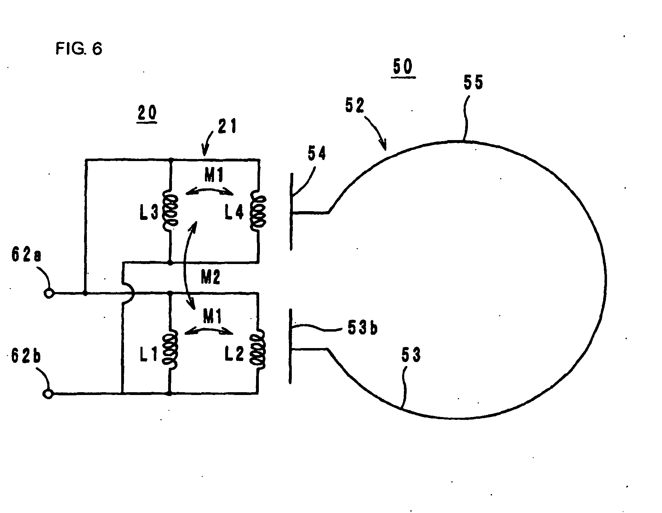

### (Third Embodiment, refer to Figs. 6 to 8)

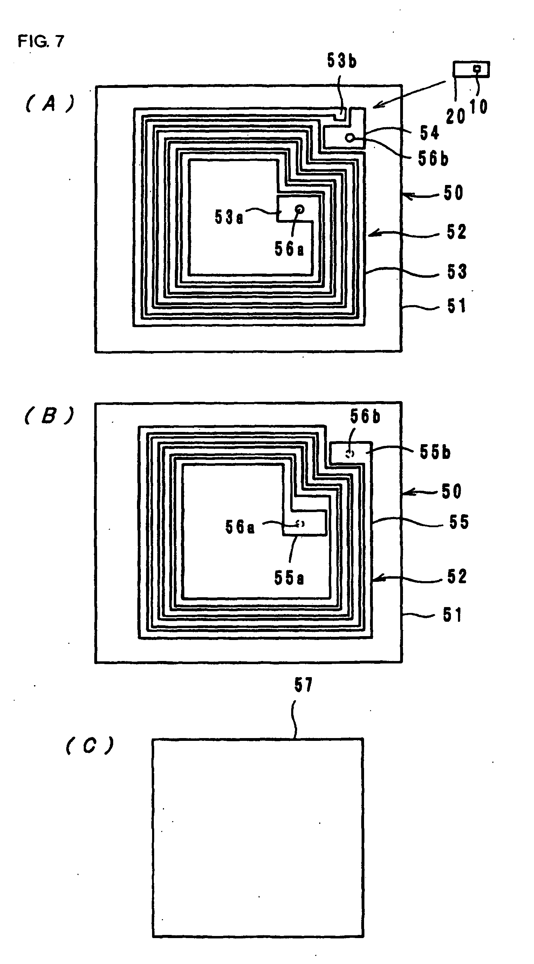

In a wireless IC device of a third embodiment, as shown in Fig. 7(A), the feeder circuit board 20 on which the wireless IC chip 10 is mounted is adhered on an end 53b of an electrode 53 and an electrode 54, which are formed on the front face of a radiation substrate 50, with adhesive. The wireless IC chip 10 of the third embodiment has the same structure as that of the first embodiment.

As shown in Fig. 7(A), the radiation substrate 50 has the spiral electrode 53 and the electrode 54 that are formed on the front face of a flexible resin film base 51 and that function as a radiation strip 52. As shown in Fig. 7(B), the radiation substrate 50 has a spiral electrode 55 that is provided on the rear face of the flexible resin film base 51 and that functions as the radiation strip 52.

An end 53a of the electrode 53 is electrically connected to an end 55a of the electrode 55 via a via-hole conductor 56a and an end 55b of the electrode 55 is electrically connected to the electrode 54 via a via-hole conductor 56b. A magnetic body 57 made of, for example, ferrite is formed on the rear face of the substrate 50. The magnetic body 57 is formed on the electrode 55 inside the outline of the electrode 55. The magnetic body 57 may be made of a magnetic metal material. In this case, it is necessary to electrically insulate the magnetic body 57 from the electrode 55.

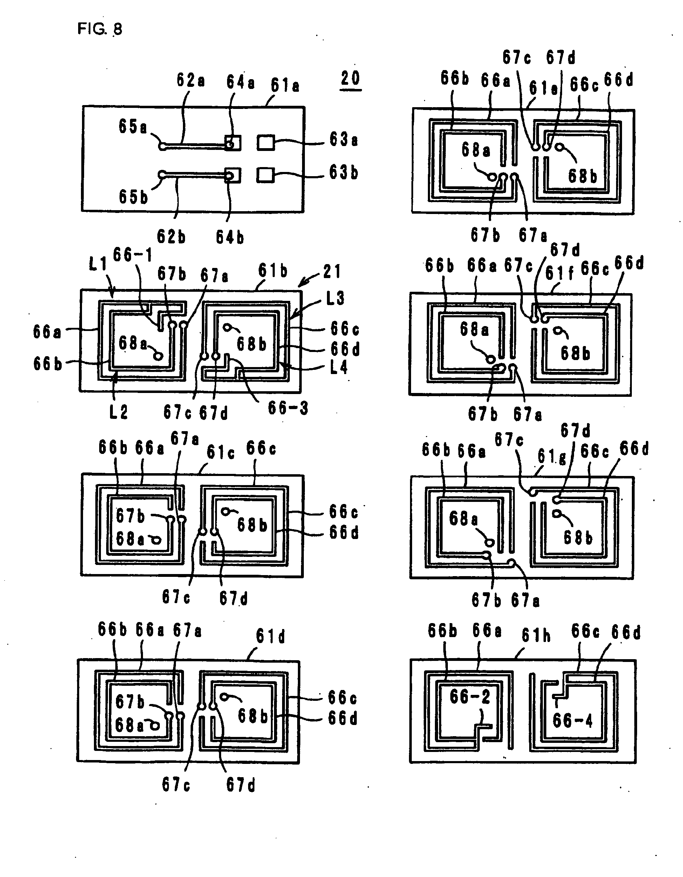

In the feeder circuit board 20, as shown in Fig. 6 as an equivalent circuit, inductance elements L1 and L2 having different inductances are magnetically coupled to each other in phase (a mutual inductance M1), and inductance elements L3 and L4 having different inductances are magnetically coupled to each other in phase (the mutual inductance M1). The inductance elements L1 and L2 are out of phase with and magnetically coupled to the inductance elements L3 and L4 (indicated by a mutual inductance M2). The feeder circuit 21 including a resonant circuit and/or a matching circuit that include the inductance elements L1, L2, L3, and L4 will be described below with reference to Fig. 8.

The inductance elements L1 and L2 included in the feeder circuit 21 are out of phase with and magnetically couple to the inductance elements L3 and L4 included in the feeder circuit 21 to resonate with the frequency processed by the wireless IC chip 10 and to be electromagnetically coupled to the electrode end 53b and the electrode 54 of the loop radiation strip 52. Feeder terminal electrode 62a and 62b in the feeder circuit 21 are electrically connected to input-output terminal electrodes (not shown) of the wireless IC chip 10 to match the impedance (normally 50Ω) of the wireless IC chip 10 with the impedance (a spatial impedance of 377Ω) of the radiation strip 52.

In the third embodiment, when a signal of a positive polarity is applied to the electrode 54 of the radiation strip 52, a signal of a negative polarity is applied to the electrode end 53b. As a result, a current flows in the direction from the positive polarity (the electrode 54) to the negative polarity (the electrode end 53b) to transmit the signal between the radiation strip 52 and the feeder circuit 21.

Accordingly, the feeder circuit 21 transmits a transmission signal that is sent from the wireless IC chip 10 and that has a predetermined frequency to the radiation strip 52 and selects a reception signal having a predetermined frequency from the signals received by the radiation strip 52 to supply the selected reception signal to the wireless IC chip 10, as in the first embodiment. Consequently, in the wireless IC device, the wireless IC chip 10 operates in response to the signal received by the radiation strip 52 and a response signal from the wireless IC chip 10 is externally radiated from the radiation strip 52. As described above, the operation and effect of the third embodiment are basically the same as those of the

### first embodiment.

The structure of the feeder circuit board 20 will now be described with reference to Fig. 8. The feeder circuit board 20 is manufactured by layering, attaching by pressure, and firing ceramic sheets 61a to 61h made of a dielectric material or a magnetic material. The feeder terminal electrodes 62a and 62b, mounting electrodes 63a and 63b, and via-hole conductors 64a, 64b, 65a, and 65b are formed on the top-layer sheet 61a. Wiring electrodes 66a, 66b, 66c, and 66d composing the inductance elements L1, L2, L3, and L4 are formed on the layers from the second-layer sheet 61b to the eighth-layer sheet 61h. Via-hole conductors 67a, 67b, 68a, and 68b are formed on the layers from the second-layer sheet 61b to the eighth-layer sheet 61h, if needed.

Layering the above sheets 61a to 61h forms the inductance element L1 in which the wiring electrodes 66a are helically connected to each other via the via-hole conductor 67a and forms the inductance element L2 in which the wiring electrodes 66b are helically connected to each other via the via-hole conductor 67b. In addition, the inductance element L3 in which the wiring electrodes 66c are helically connected to each other via the via-hole conductor 67c is formed and the inductance element L4 in which the wiring electrodes 66d are helically connected to each other via the via-hole conductor 67d is formed. Capacitances are generated between the lines of the wiring electrodes 66a, 66b, 66c, and 66d.

An end 66-1 where the wiring electrode 66a is integrated with the wiring electrode 66b on the sheet 61b is connected to the feeder terminal electrode 62a via the via-hole conductors 65a, and an end 66-2 where the wiring electrode 66a is integrated with the wiring electrode 66b on the sheet 41h is connected to the feeder terminal electrode 62b via the via-hole conductors 68a and 65b. An end 66-3 where the wiring electrode 66c is integrated with the wiring electrode 66d on the sheet 61b is connected to the feeder terminal electrode 62b via the via-hole conductors 64b, and 66-4 where the wiring electrode 66c is integrated with the wiring electrode 66d on the sheet 61h is connected to the feeder terminal electrode 62a via the via-hole conductors 68b and 64a.

The operation of the feeder circuit 21 having the above structure is basically the same as that of the feeder circuit 21 described above in the first embodiment. Particularly, since the inductance elements L1 and L2 are formed of the two wiring electrodes 66a and 66b, which are adjacent to each other on the same plane, and the inductance elements L3 and L4 are formed of the wiring electrodes 66c and 66d, which are adjacent to each other on the same plane, the lengths of the wiring electrodes or the distance between the electrodes can be varied to broaden the resonance characteristics.

The radiation strip 52 is composed of a loop electrode having one end electrode 53a and the other end electrode 54, and the end electrodes 53a and 54 are coupled to the inductance elements L1 and L2 and the inductance elements L3 and L4, respectively. Since the magnetic body 57 is arranged inside the outline of the loop of the loop electrode, the magnetic field generated around the radiation strip 52 composed of the loop electrode is amplified to increase the communication distance. The magnetic body 57 may not necessarily be provided and may be omitted.

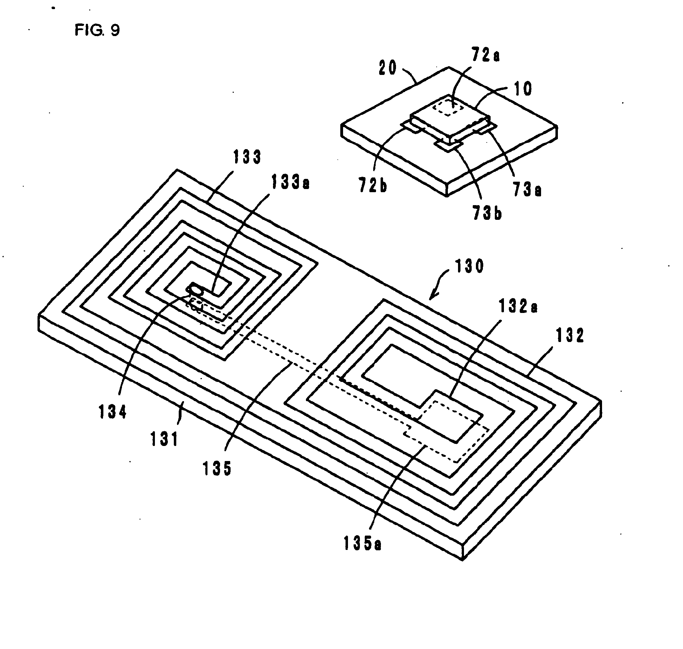

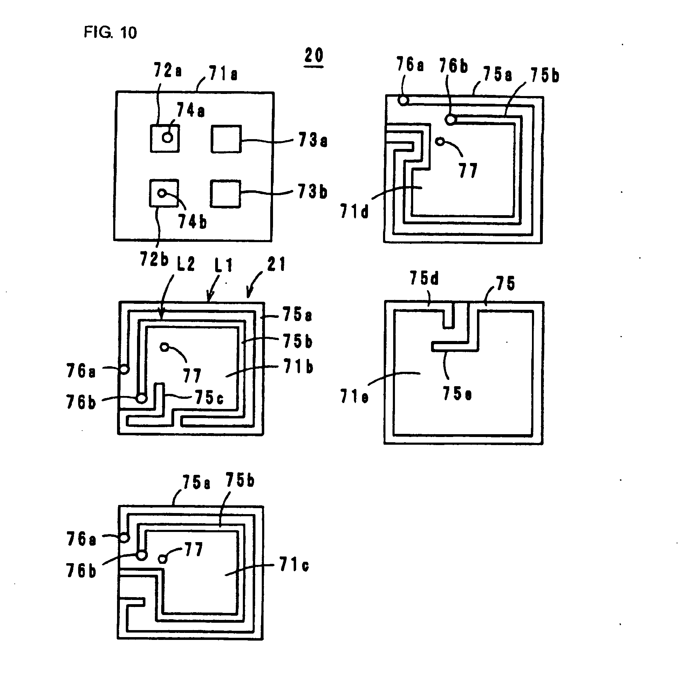

### (Fourth Embodiment, refer to Figs. 9 and 10)

A wireless IC device of a fourth embodiment includes the wireless IC chip 10, the feeder circuit board 20, and a radiation substrate 130 on which a radiation strip 132 is formed, as shown in Fig. 9.

The wireless IC chip 10 of the fourth embodiment has the same structure as that of the first embodiment. The feeder circuit board 20 includes the two inductance elements L1 and L2. Feeder terminal electrodes 72a and 72b and mounting electrodes 73a and 73b provided on the front face of the feeder circuit board 20 are electrically connected to input-output terminal electrodes and mounting terminal electrodes (which are not shown) below the wireless IC chip 10.

On the radiation substrate 130, the radiation strip 132 is helically formed on a half area of the front face of a base 131 made of ceramics and an auxiliary electrode 133 is helically formed on the other half area. The feeder circuit board 20 on which the wireless IC chip 10 is mounted is adhered on the radiation strip 132 with adhesive. In the auxiliary electrode 133, an end 133a at the central portion of the auxiliary electrode 133 is connected to an electrode 135 formed on the rear face of the base 131 via a via-hole conductor 134, and an end 135a of the electrode 135 is capacitively coupled to an end 132a at the central portion of the radiation strip 132. The electrode 135 may be formed inside the base 131.

The feeder circuit board 20 is manufactured by layering, attaching by pressure, and firing ceramic sheets 71a to 71e made of a dielectric material or a magnetic material, as shown in Fig. 10. The feeder terminal electrodes 72a and 72b, the mounting electrodes 73a and 73b, and via-hole conductors 74a and 74b are formed on the top-layer sheet 71a. Wiring electrodes 75a and 75b composing the inductance elements L1 and L2, respectively, and via-hole conductors 76a, 76b, and 77 are formed on the layers from the second-layer sheet 71b to the fourth-layer sheet 71d. A wiring electrode 75 is formed on the bottom-layer sheet 71e. The wiring electrodes 75a and 75 are formed in a state where the wiring electrodes 75a and 75 are bare along the periphery of the sheets 71b to 71e.

Layering the above sheets 71a to 71e forms the inductance element L1 in which the wiring electrodes 75a are helically connected to each other via the via-hole conductor 76a and forms the inductance element L2 in which the wiring electrodes 75b are helically connected to each other via the via-hole conductor 76b. The wiring electrodes 75a and 75b branch off on the sheet 71b and the wiring electrodes 75a and 75b are integrated into the wiring electrode 75 on the bottom-layer sheet 71e. A capacitance is generated between the lines of the wiring electrodes 75a and 75b.

An end 75c where the wiring electrode 75a is integrated with the wiring electrode 75b on the sheet 71b is connected to the feeder terminal electrode 72b via the via-hole conductor 74b, an end 75d of the wiring electrode 75 on the sheet 71e is connected to the wiring electrodes 75a and 75b via the via-hole conductors 76a and 76b on the sheet 71d above the sheet 71e, and an end 75e of the wiring electrode 75 is connected to the feeder terminal electrode 72a via the via-hole conductors 77 and 74a.

The feeder circuit 21, which has the above structure and which includes the inductance elements L1 and L2, has an equivalent circuit similar to that of the feeder circuit 21 shown in Fig. 1. The inductance element L1 is out of phase with and electromagnetically coupled to the inductance element L2 to resonate with the frequency processed by the wireless IC chip 10 and to be electromagnetically coupled to the radiation strip 132. The feeder circuit 21 matches the impedance (normally 50Ω) of the wireless IC chip 10 with the impedance (a spatial impedance of 377Ω) of the radiation strip 132.

Accordingly, the operation and effect of the fourth embodiment are the same as those of the first embodiment. Particularly, since part (the wiring electrodes 75a and 75) of the inductance elements L1 and L2 is bare along the side faces of the feeder circuit board 20 in the fourth embodiment, the part that is exposed to the outside also functions as the radiation strip. In addition, the part of the inductance elements L1 and L2 exposed to the outside is electromagnetically coupled to the radiation strip 132 and the auxiliary electrode 133 on the side faces of the feeder circuit board 20, so that the radiation characteristics are improved. The external dimension of the auxiliary electrode 133 is the same as or greater than that of the feeder circuit board 20 and, thus, the coupling to the magnetic field radiated from the rear face and the side faces of the feeder circuit board 20 is easily achieved.

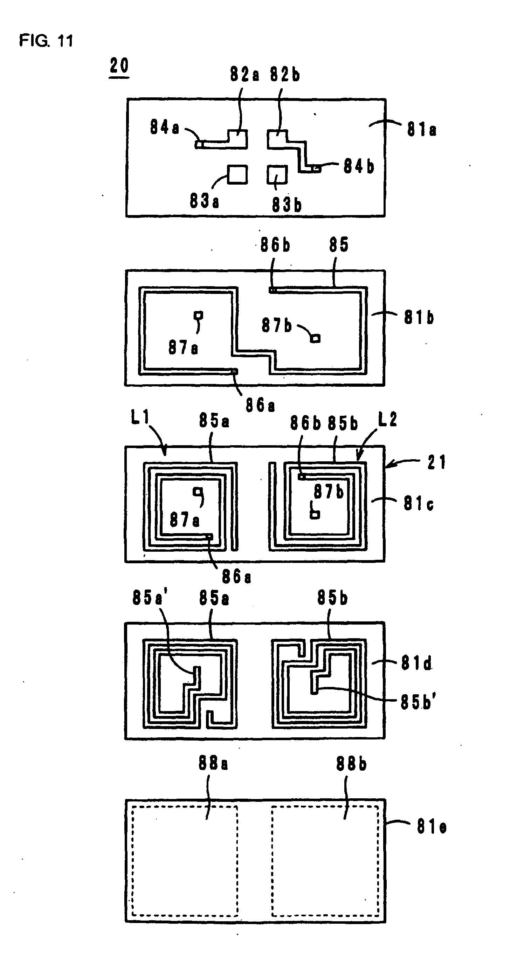

### (Fifth Embodiment, refer to Fig. 11)

A wireless IC device of a fifth embodiment includes the feeder circuit board 20 shown in Fig. 11. The wireless IC chip 10 and the radiation substrate 30, which are the remaining components of the wireless IC device, are the same as those described in the first embodiment.

The feeder circuit board 20 is manufactured by layering, attaching by pressure, and firing ceramic sheets 81a to 81e made of a dielectric material or a magnetic material. Feeder terminal electrodes 82a and 82b, mounting electrodes 83a and 83b, and via-hole conductors 84a and 84b are formed on the top-layer sheet 81a. A wiring electrode 85 and via-hole conductors 86a, 86b, 87a, and 87b are formed on the second-layer sheet 81b. Wiring electrodes 85a and 85b composing the inductance elements L1 and L2 and the via-hole conductors 86a, 86b, 87a, and 87b are formed on the third-layer sheet 81c. The wiring electrodes 85a and 85b composing the inductance elements L1 and L2 are formed on the fourth-layer sheet 81d. Planer electrodes 88a and 88b are formed on rear face of the bottom-layer sheet 81e.

Layering the above sheets 81a to 81e forms the inductance element L1 in which the wiring electrodes 85a are helically connected to each other via the via-hole conductor 86a and forms the inductance element L2 in which the wiring electrodes 85b are helically connected to each other via the via-hole conductor 86b. A capacitance is generated between the lines of the wiring electrodes 85a and 85b.

The wiring electrodes 85a and 85b are integrated into the wiring electrode 85 on the sheet 81b, an end 85a' of the wiring electrode 85a on the sheet 81d is connected to the feeder terminal electrode 82a via the via-hole conductors 87a and 84a, and an end 85b' of the wiring electrode 85b on the sheet 81d is connected to the feeder terminal electrode 82b via the via-hole conductors 87b and 84b.

The feeder circuit 21, which has the above structure and which includes the inductance elements L1 and L2, has an equivalent circuit similar to that of the feeder circuit 21 shown in Fig. 1. The inductance element L1 is out of phase with and electromagnetically coupled to the inductance element L2 to resonate with the frequency processed by the wireless IC chip 10 and to be electromagnetically coupled to the radiation strip 32. The feeder circuit 21 matches the impedance (normally 50Ω) of the wireless IC chip 10 with the impedance (a spatial impedance of 377Ω) of the radiation strip 32.

Accordingly, the operation and effect of the fifth embodiment are the same as those of the first embodiment. Particularly, the provision of the planer electrodes 88a and 88b on the rear face of the feeder circuit board 20 allows a variation in coupling between the feeder circuit 21 and the radiation strip 32 to be suppressed. The planer electrodes 88a and 88b may not necessarily be provided.

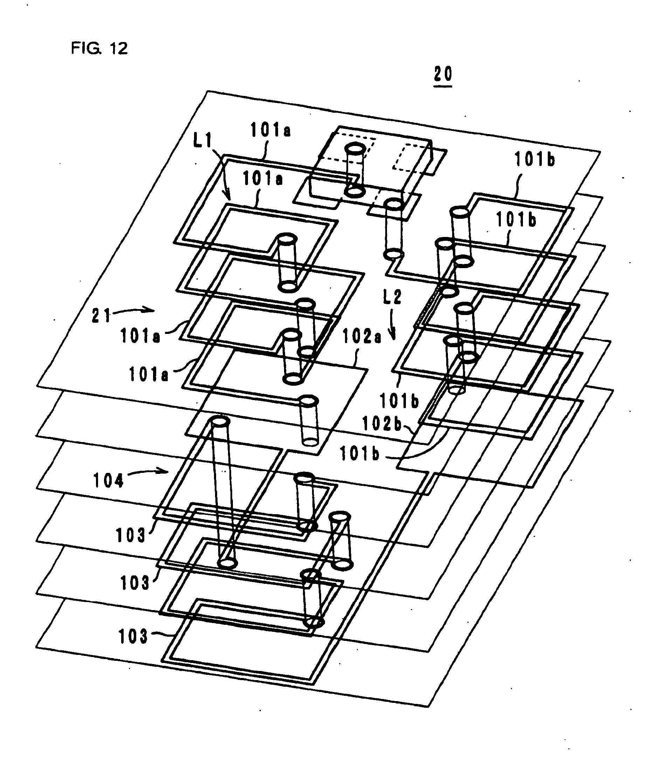

### (Sixth Embodiment, refer to Fig. 12)

A wireless IC device of a sixth embodiment includes the feeder circuit board 20 shown in Fig. 12. The wireless IC chip 10 and the radiation substrate 30, which are the remaining components of the wireless IC device, are the same as those described in the first embodiment.

The structure of the feeder circuit board 20 is basically the same as that of the feeder circuit board 20 shown in the first embodiment. Wiring electrodes 101a and 101b helically connected to each other form the inductance elements L1 and L2, respectively. The inductance elements L1 and L2 have different inductances and are out of phase with and magnetically coupled to each other.

Planer electrodes 102a and 102b are arranged beneath the inductance elements L1 and L2, and wiring electrodes 103 helically connected to each other form a magnetic-field receiving coil 104. The magnetic-field receiving coil 104 is connected in series to the planer electrodes 102a and 102b and has an auxiliary radiation function for coupling the feeder circuit 21 to the radiation strip 32 (refer to Fig. 2).

The feeder circuit 21 of the sixth embodiment, which includes the inductance elements L1 and L2, has an equivalent circuit similar to that of the feeder circuit 21 shown in Fig. 1. The inductance element L1 is out of phase with and electromagnetically coupled to the inductance element L2 to resonate with the frequency processed by the wireless IC chip 10 and to be electromagnetically coupled to the radiation strip 32. The feeder circuit 21 matches the impedance (normally 50Ω) of the wireless IC chip 10 with the impedance (a spatial impedance of 377Ω) of the radiation strip 32. Accordingly, the operation and effect of the sixth embodiment are similar to those of the first embodiment.

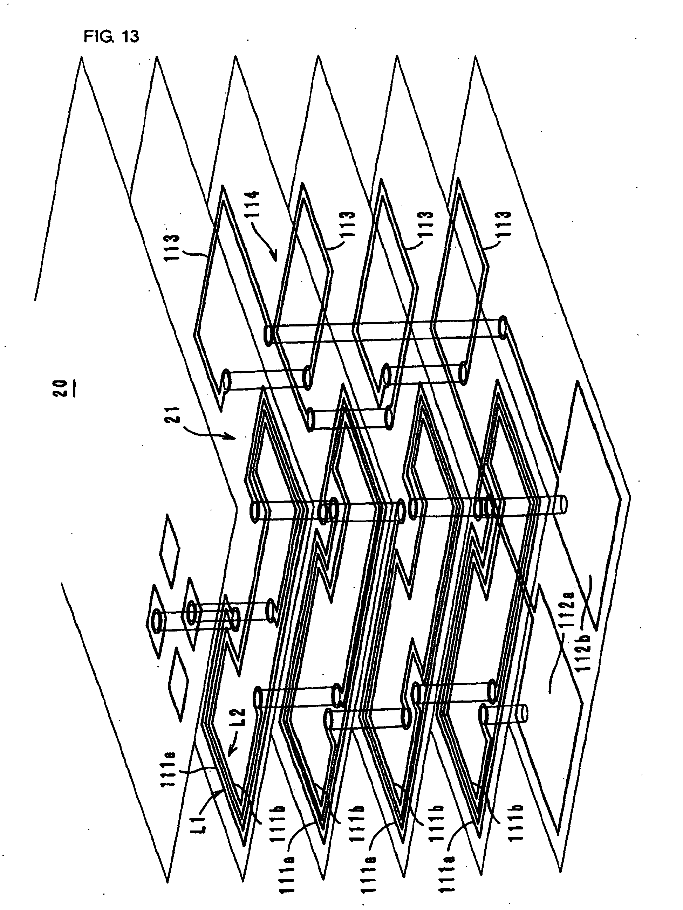

### (Seventh Embodiment, refer to Fig. 13)

A wireless IC device of a seventh embodiment includes the feeder circuit board 20 shown in Fig. 13. The wireless IC chip 10 and the radiation substrate 30, which are the remaining components of the wireless IC device, are the same as those described in the first embodiment.

In the feeder circuit board 20, wiring electrodes 111a and 111b that are adjacent to each other and that are helically connected to each other form the inductance elements L1 and L2, respectively. The inductance elements L1 and L2 have different inductances and are out of phase with and magnetically coupled to each other.

Planer electrodes 112a and 112b are arranged beneath the inductance elements L1 and L2, and wiring electrodes 113 that are helically connected to each other form a magnetic-field receiving coil 114. The magnetic-field receiving coil 114 is connected in series to the planer electrodes 112a and 112b and has an auxiliary radiation function for coupling the feeder circuit 21 to the radiation strip 32 (refer to Fig. 2).

The feeder circuit 21 of the seventh embodiment, which includes the inductance elements L1 and L2, has an equivalent circuit similar to that of the feeder circuit 21 shown in Fig. 1. The inductance element L1 is out of phase with and electromagnetically coupled to the inductance element L2 to resonate with the frequency processed by the wireless IC chip 10 and to be electromagnetically coupled to the radiation strip 32. The feeder circuit 21 matches the impedance (normally 50Ω) of the wireless IC chip 10 with the impedance (a spatial impedance of 377Ω) of the radiation strip 32. Accordingly, the operation and effect of the seventh embodiment are similar to those of the first embodiment.

Particularly, in the seventh embodiment, since the inductance elements L1 and L2 are composed of the two wiring electrodes 111a and 111b that are adjacent to each other on the same plane, respectively, the lengths of the wiring electrodes 111a and 111b or the distance between the wiring electrodes 1l1a and 11b can be varied to broaden the resonance characteristics.

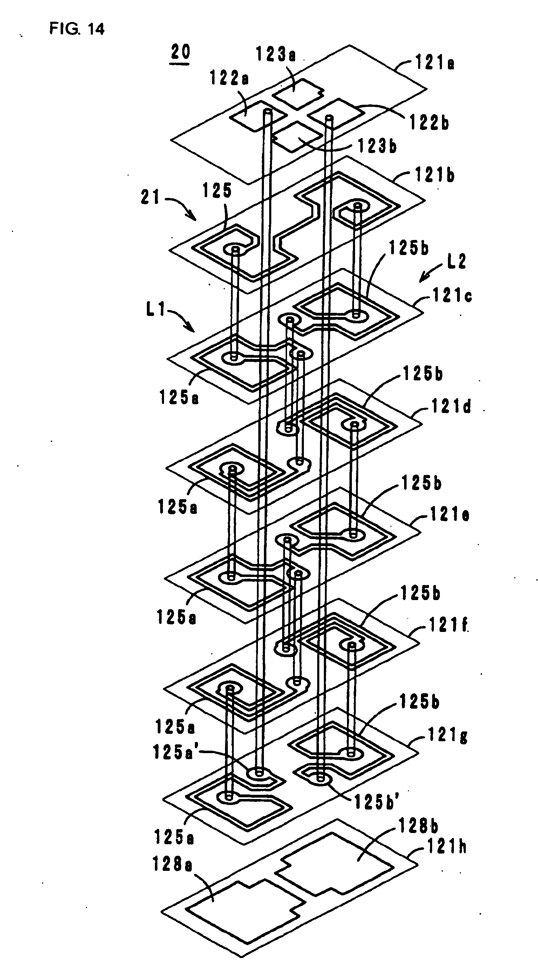

### (Eighth Embodiment, refer to Figs. 14 to 17)

A wireless IC device of an eighth embodiment includes the feeder circuit board 20 shown in Fig. 14. The feeder circuit 21 on the feeder circuit board 20 is basically the same as in the fifth embodiment (refer to Fig. 11). Specifically, feeder terminal electrodes 122a and 122b and mounting electrode 123a and 123b are formed on a sheet 121a, and wiring electrodes 125a and 125b are formed on sheets 121b to 121g. Planer electrodes 128a and 128b are formed on a sheet 121h.

The inductance elements L1 and L2 are formed by helically connecting the wiring electrodes 125a and 125b, respectively, and the wiring electrodes 125a and 125b are integrated into a wiring electrode 125 on the sheet 121b. An end 125a' of the wiring electrode 125a on the sheet 121g is connected to the feeder terminal electrode 122a and an end 125b' of the wiring electrode 125b on the sheet 121g is connected to the feeder terminal electrode 122b.

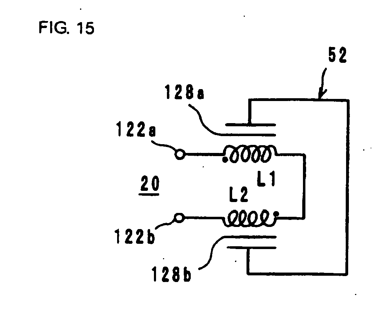

The feeder circuit 21, which has the above structure and which includes the inductance elements L1 and L2, has an equivalent circuit shown in Fig. 15. The inductance elements L1 and L2 connected in series to the wireless IC chip 10 are out of phase with and electromagnetically coupled to each other to resonate with the frequency processed by the wireless IC chip 10 and to be electromagnetically coupled to the radiation strip 52 (may be the radiation strip 32). The feeder circuit 21 matches the impedance (normally 50Ω) of the wireless IC chip 10 with the impedance (a spatial impedance of 377Ω) of the radiation strip 32, 52.

Accordingly, the operation and effect of the eighth embodiment are similar to those of the first embodiment. Particularly, the provision of the planer electrodes 128a and 128b on the rear face of the feeder circuit board 20 allows a variation in coupling between the feeder circuit 21 and the radiation strip 32, 52 to be suppressed. The planer electrodes 128a and 128b may not necessarily be provided.

Furthermore, in the eighth embodiment, the positions where the ends of the inductance elements L1 and L2 are connected to the feeder terminal electrodes 122a and 122b can be varied and the ends 125a' and 125b' can be electrically opened to compose an auxiliary matching circuit.

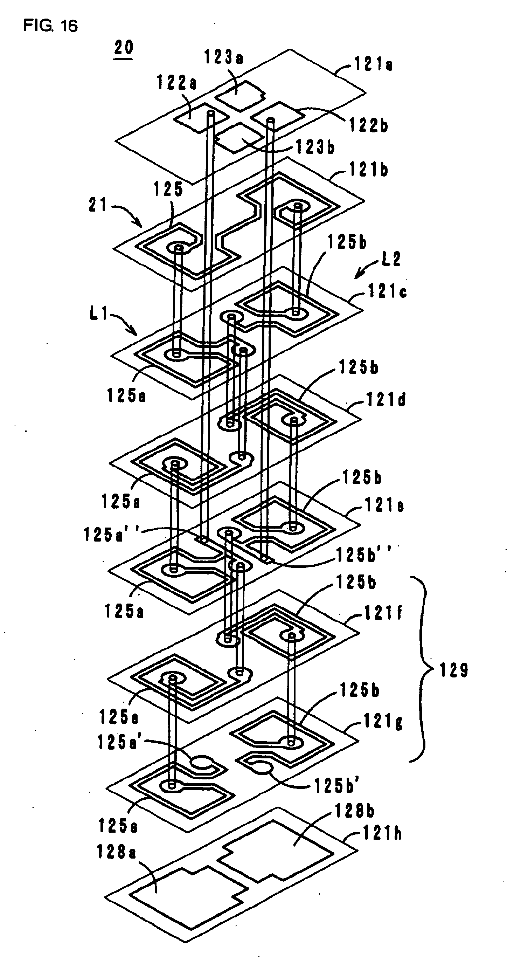

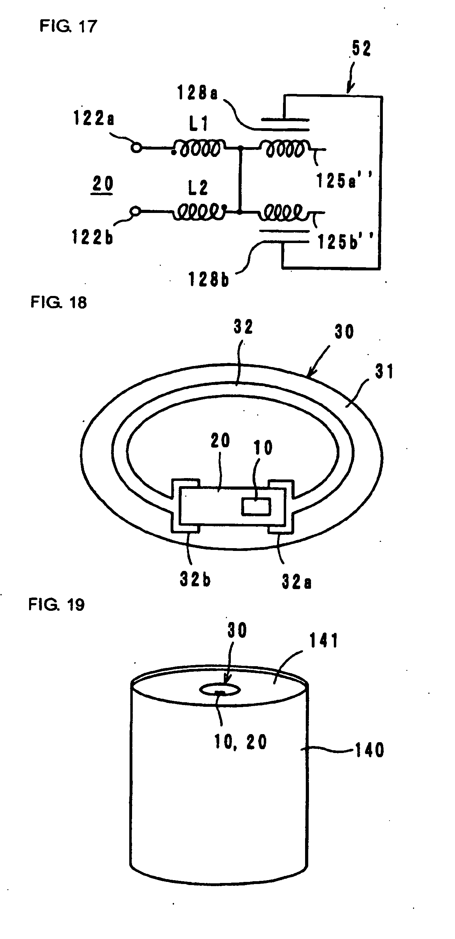

For example, as shown in Fig. 16, extending electrodes 125a" and 125b" are formed for the wiring electrodes 125a and 125b on the sheet 121e and the extending electrodes 125a" and 125b" are connected to the feeder terminal electrodes 122a and 122b, respectively. The ends 125a' and 125b' of the wiring electrodes 125a and 125b on the sheet 121g are electrically opened to form an auxiliary matching circuit 129 by using the wiring electrodes 125a and 125b on the sheets 121f and 121g. The extending electrodes 125a" and 125b" connected to the feeder terminal electrodes 122a and 122b, respectively, may be any of the wiring electrodes 125a and 125b provided on the sheets 121c to 121f. An equivalent circuit including the extending electrodes 125a" and 125b" is shown in Fig. 17. The formation of the auxiliary matching circuit 129 enables fine adjustment of the matching state.

### (Ninth Embodiment, refer to Figs. 18 to 20)

In a wireless IC device of a ninth embodiment, the feeder circuit board 20 provided with the wireless IC chip 10 is adhered on the radiation substrate 30, as shown in Fig. 18, and the radiation substrate 30 is adhered to a depression 141 on the front face or the rear face of a metal can 140, as shown in Fig. 19. The metal can 140 is made of a metallic material, such as steel or aluminum. The feeder circuit board 20 is the same as the one shown in the first embodiment and has the feeder circuit 21 shown in Fig. 4. The radiation substrate 30 has the loop radiation strip 32 shown in Fig. 2 formed thereon. The radiation strip 32 is provided on the film base 31 and has the ends 32a and 32b. However, the film base 31 and the radiation strip 32 shown in Fig. 2 have quadrangular shapes whereas the film base 31 and the radiation strip 32 of the ninth embodiment have elliptical shapes, as shown in Fig. 18.

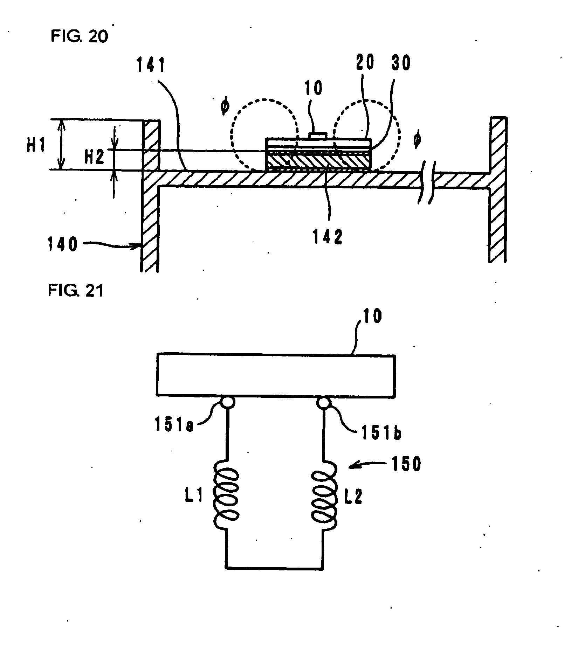

As shown in Fig. 20, the radiation substrate 30 provided with the wireless IC chip 10 and the feeder circuit board 20 is adhered on the bottom of the depression 141 via a mount 142 having adhesive on both sides. A depth H1 of the depression 141 is about five mm and a distance H2 from the bottom of the depression 141 to the radiation strip 32 is around two to three mm. The wireless IC chip 10 does not preferably protrude from the depression 141.

The operation and effect of the ninth embodiment are similar to those of the first embodiment. Upon transmission or reception of a signal, magnetic fields φ (refer to Fig. 20) are generated around the loop radiation strip 32. Since the magnetic fields do not pass through a metal, arranging a metal in parallel with and close to the radiation strip 32 causes the magnetic fields generated around the radiation strip 32 to be blocked by the metal. In such a case, the magnetic fields are not sufficiently radiated externally to cause the insufficient operation of the wireless IC device. Accordingly, as in the ninth embodiment, arranging the radiation strip 32 away from the bottom of the depression 141 of the radiation strip metal can 140 by about a few millimeters via, for example, the mount 142 allows the magnetic fields φ to be radiated from the radiation strip 32 to ensure the operation of the wireless IC device.

The radiation substrate 30 provided with the feeder circuit board 20 may be embedded in the mount 142. Alternatively, the radiation substrate 30 may have a thickness similar to that of the mount 142 and the feeder circuit board 20 may be embedded in a depression formed in the radiation substrate 30. Alternatively, the wireless IC chip 10 may be arranged so as to be sandwiched between the feeder circuit board 20 and the radiation substrate 30. With the above structures, it is possible to protect the wireless IC chip and the feeder circuit board 20 from dropping or impact to improve the mechanical strength of the wireless IC device. Although the wireless IC device is adhered to the metal can 140 in the ninth embodiment, the object to which the wireless IC device is adhered is not restricted to the metal can. The wireless IC device may be adhered to any metallic article, such as a metallic case or a ground electrode on the circuit board.

### (Tenth Embodiment, refer to Figs. 21 to 23)

The feeder circuit boards each include the feeder circuit board provided with the feeder circuit including a resonant circuit and/or a matching circuit in the above embodiments. However, a feeder circuit including a resonant circuit and/or a matching circuit that include at least two inductance elements may be provided on the rear face (the main face) of the wireless IC chip where the input-output terminal electrodes are formed, without providing the feeder circuit board. Such wireless IC devices will be described as a tenth embodiment and an eleventh embodiment.

In a wireless IC device of the tenth embodiment, a feeder circuit 150 shown in Fig. 21 as an equivalent circuit is provided on the rear face of the wireless IC chip 10. The feeder circuit 150 is composed of the two helically-formed inductance elements L1 and L2 that are wound in opposite directions and that are connected in series to each other. Feeder terminal electrodes 151a and 151b provided at ends of the respective inductance elements L1 and L2 are electrically conducted to an input terminal electrode and an output terminal electrode of the wireless IC chip 10. The inductance elements L1 and L2 are out of phase with and electromagnetically coupled to each other, a resonant circuit composed of the inductance elements L1 and L2 and a stray capacitance between the lines resonates with the frequency processed by the wireless IC chip 10, and the inductance elements L1 and L2 are electromagnetically coupled to a radiation strip (for example, the ends 32a and 32b of the radiation strip 32 shown in Fig. 2). Accordingly, the operation and effect of the tenth embodiment is similar to those of the first embodiment.

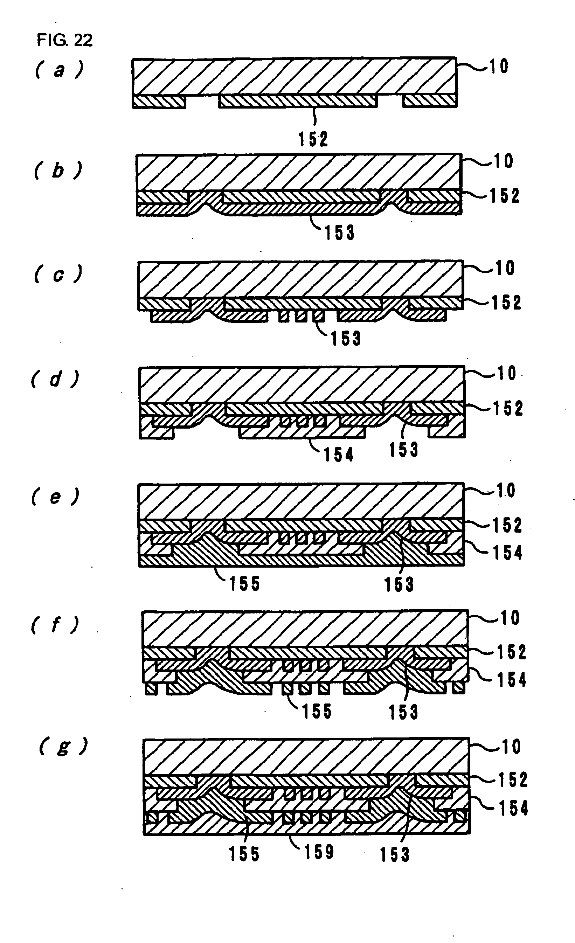

In the feeder circuit 150, a midpoint between the inductance elements L1 and L2 serves as a virtual ground. In addition, the impedance of the feeder circuit 150 is designed so as to make a complex conjugate with the impedance of the wireless IC chip 10. Since the inductance elements L1 and L2 are formed in a layered state shown in Fig. 22, the inductance elements L1 and L2 have different inductances depending on the distance to the radiation strip. Accordingly, an insulating layer 159 is formed on the rear face of the wireless IC chip 10 to fix the distance from the radiation strip and to protect the inductance elements L1 and L2.

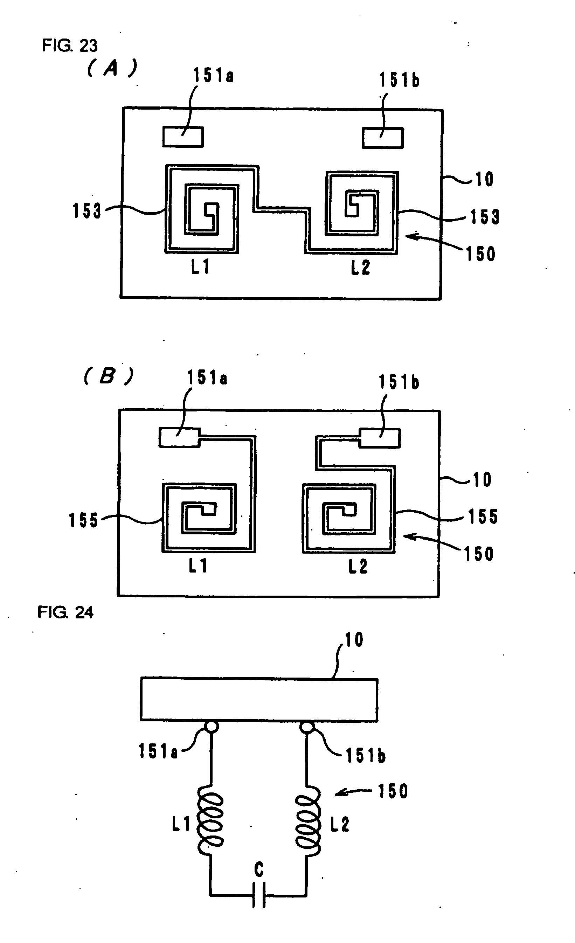

The feeder circuit 150 is manufactured through processes shown in Fig. 22. First, as shown in Fig. 22(a), an insulating layer 152 is formed on the rear face of the wireless IC chip 10. The insulating layer 152 is not formed at the parts where the input-output terminal electrodes are provided. Next, as shown in Fig. 22(b), an electrode layer 153 is formed on the insulating layer 152 by plating or the like and the electrode layer 153 is etched into a certain shape (refer to Fig. 22(c)). This state is shown in Fig. 23(A).

Next, as shown in Fig. 22(d), an insulating layer 154 is formed on the electrode layer 153. In addition, as shown in Fig. 22(e), an electrode layer 155 is formed on the insulating layer 154 by plating or the like and the electrode layer 155 is etched into a certain shape (refer to Fig. 22(f)). This state is shown in Fig. 23(B). In addition, as shown in Fig. 22(g), the insulating layer 159 is formed on the electrode layer 155.

### (Eleventh Embodiment, refer to Figs. 24 to 26)

In a wireless IC device of the eleventh embodiment, the feeder circuit 150 shown in Fig. 24 as an equivalent circuit is provided on the rear face of the wireless IC chip 10. In the feeder circuit 150, a capacitor C is provided between the inductance elements L1 and L2 in the equivalent circuit (refer to Fig. 21) shown in the ninth embodiment to form a serial resonant circuit. The operation and effect of the eleventh embodiment are similar to those of the first embodiment.

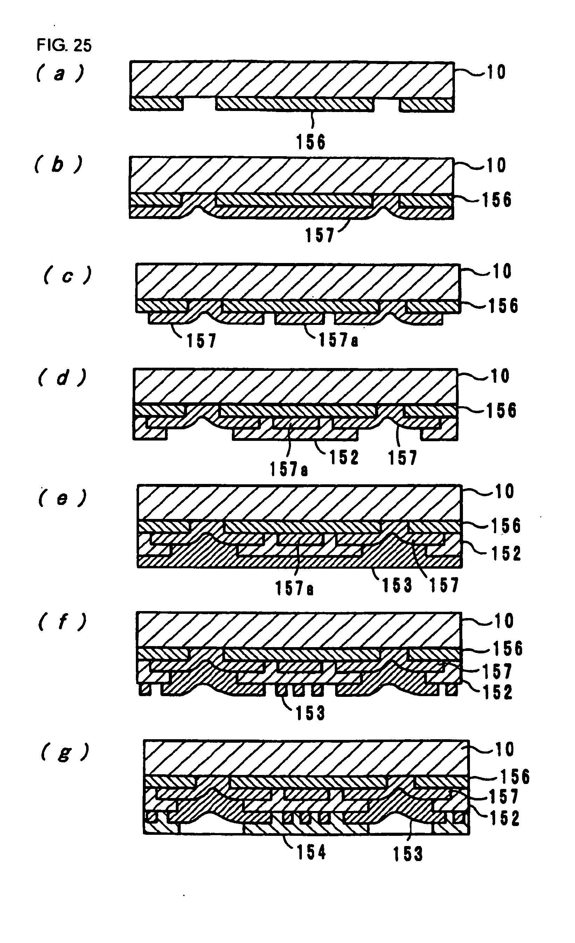

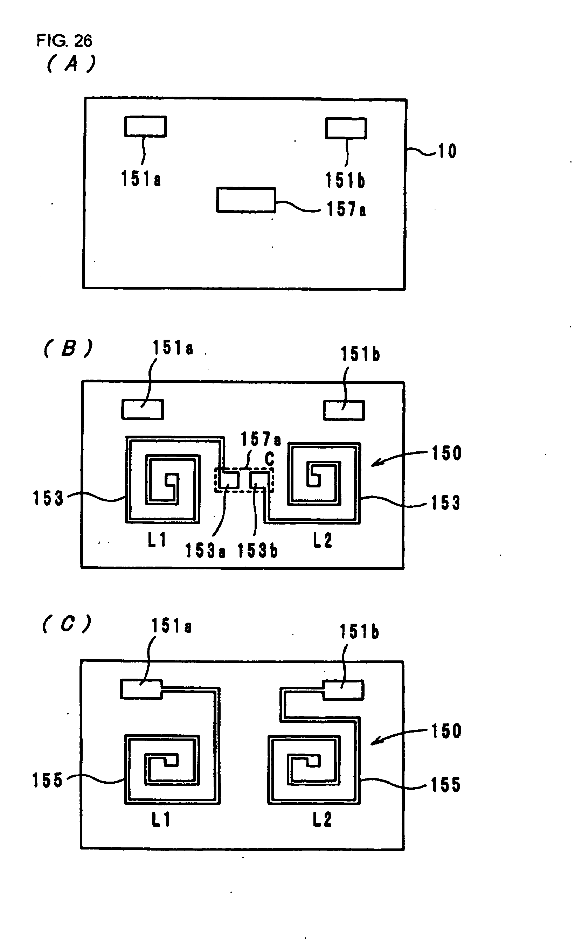

The feeder circuit 150 shown in Fig. 24 is manufactured through processes shown in Fig. 25. First, as shown in Fig. 25(a), an insulating layer 156 is formed on the rear face of the wireless IC chip 10. The insulating layer 156 is not formed at the parts where the input-output terminal electrodes are provided. Next, as shown in Fig. 25(b), an electrode layer 157 is formed on the insulating layer 156 by plating or the like and the electrode layer 157 is etched into a certain shape (refer to Fig. 25(c)). This state is shown in Fig. 26(A), in which an electrode 157a remaining at a central portion serves as a capacitor electrode.

Next, as shown in Fig. 25(d), the insulating layer 152 is formed on the electrode layer 157. In addition, as shown in Fig. 25(e), the electrode layer 153 is formed on the insulating layer 152 by plating or the like and the electrode layer 153 is etched into a certain shape (refer to Fig. 25(f)). This state is shown in Fig. 26(B). Electrodes 153a and 153b opposing the capacitor electrode 157a are formed at this stage.

In addition, as shown in Fig. 25(g), the insulating layer 154 is formed on the electrode layer 153.
Subsequently, the electrode layer 155 and the insulating layer 159 are formed in the manner shown in Figs. 22(e), (f), and (g). The state after the electrode layer 155 is formed is shown in Fig. 26(C).

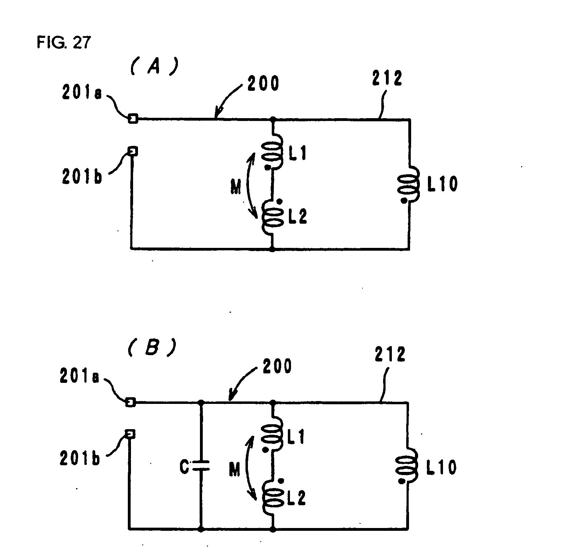

### (Twelfth to Fifteenth Embodiments, refer to Figs. 27 to 31)

A wireless IC device of a twelfth embodiment includes a feeder circuit 200 in which the helically-formed inductance elements L1 and L2 wound in opposite directions are connected in series to each other, as shown in an equivalent circuit in Fig. 27(A). Both ends of a radiation strip 212 composed of a loop electrode including an inductance component L10 are electrically conducted to both ends of the inductance elements L1 and L2. Feeder terminal electrodes 201a and 201b connected to the input terminal electrode and the output terminal electrode of the wireless IC chip 10 are formed at both ends of the feeder circuit 200.

In a wireless IC device of a thirteenth embodiment, as shown in an equivalent circuit in Fig. 27(B), a capacitor C is provided in parallel with the inductance elements L1 and L2. The remaining structure is similar to the structure of the twelfth embodiment.

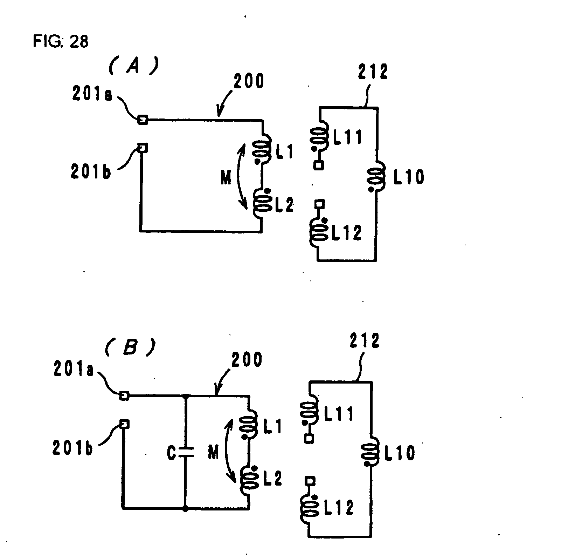

A wireless IC device of a fourteenth embodiment includes the feeder circuit 200 in which the helically-formed inductance elements L1 and L2 wound in opposite directions are connected in series to each other, as shown in an equivalent circuit in Fig. 28(A). Helical inductance components L11 and L12 provided at both ends of the radiation strip 212 composed of the loop electrode including the inductance component L10 are electromagnetically coupled to the inductance elements L1 and L2, respectively. The feeder terminal electrodes 201a and 201b connected to the input terminal electrode and the output terminal electrode of the wireless IC chip 10 are formed at both ends of the feeder circuit 200.

In a wireless IC device of a fifteenth embodiment, as shown in an equivalent circuit in Fig. 28(B), the capacitor C is provided in parallel with the inductance elements L1 and L2. The remaining structure is similar to the structure of the fourteenth embodiment.

In the fourteenth embodiment and the fifteenth embodiment, the helical receiving electrodes (the inductance components L11 and L12) are provided at both ends of the radiation strip 212 so as to oppose the inductance elements L1 and L2 in the feeder circuit 200. This allows the direction of the magnetic field generated around the inductance component L10 of the radiation strip 212 to be the same as the direction of the magnetic field generated in the feeder circuit 200, thus improving the degree of coupling between the feeder circuit 200 and the radiation strip 212.

Setting the helical directions of the receiving electrodes (the inductance components L11 and L12) provided at both ends of the radiation strip 212 to opposite directions causes the efficiency of energy transfer to be improved. In addition, the inductance elements and the helical ends of the radiation strip 212 (L1 and L11 and L2 and L12), which are formed so as to be coupled to each other, are formed so as to be wound in the same direction in a perspective plan view of the feeder circuit 200. The magnetic fields of the same direction are generated in the respective two helical electrodes (L1 and L11 and L2 and L12) arranged so as to be opposed to each other in the perspective plan view, thus further increasing the degree of the magnetic-field coupling between the feeder circuit 200 and the radiation strip 212.

Furthermore, the inductance (L10) of the loop electrode of the radiation strip 212 is set to a value higher than the inductances of the inductance elements L1 and L2 in the feeder circuit 200. Since signals generated in the feeder circuit 200 can be transmitted and received with the magnetic field generated around the radiation strip 212, it is possible to suppress an occurrence of communication failure with a reader-writer.

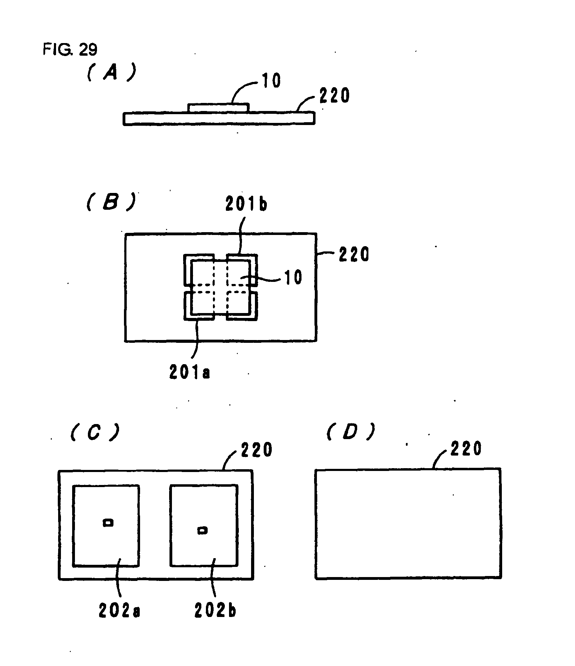

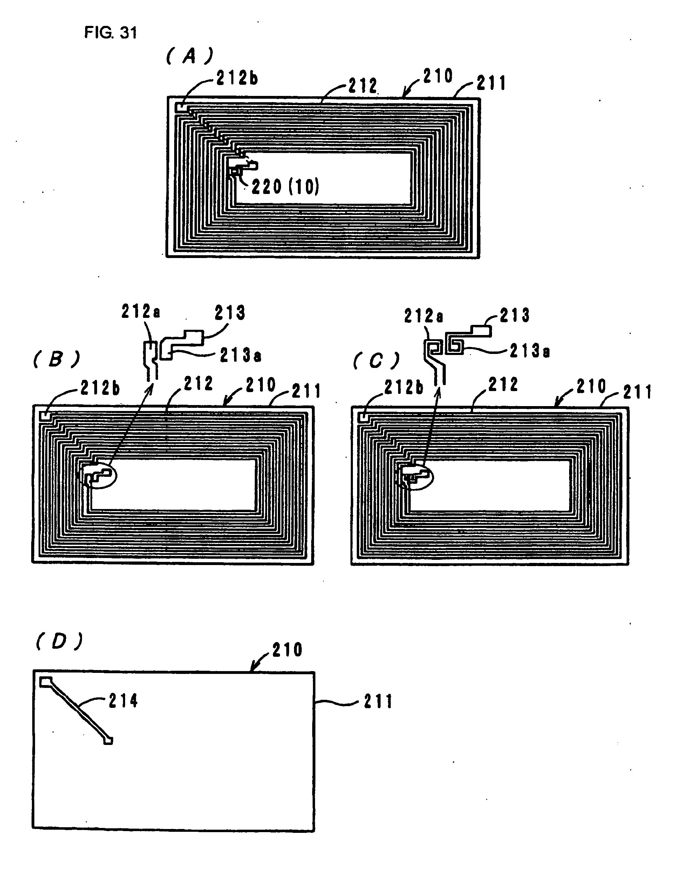

Specific structures from the twelfth embodiment to the fifteenth embodiment shown as the equivalent circuits will now be described. As shown in Fig. 29, these wireless IC devices each include the wireless IC chip 10, a feeder circuit board 220, and a radiation substrate 210 provided with the radiation strip 212 (refer to Fig. 31). The feeder terminal electrodes 201a and 201b are formed on the front face of the feeder circuit board 220 (refer to Fig. 29(B)) and planar electrodes 202a and 202b are provided on the rear face thereof (refer to Fig. 29(C)). The planar electrodes 202a and 202b have the operation and effect described in the second embodiment (refer to Fig. 5). As shown in Fig. 29(D), the planar electrodes 202a and 202b may be omitted.

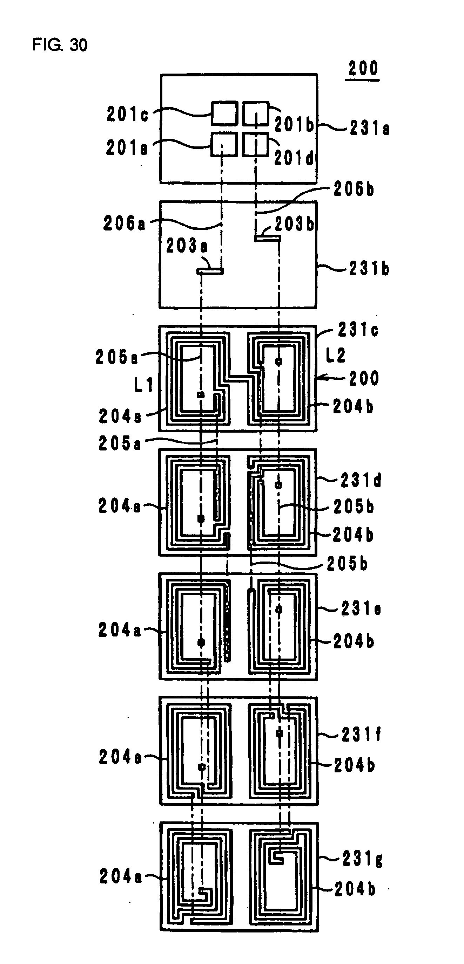

The feeder circuit 200 shown in Fig. 30 is formed inside the feeder circuit board 220. The feeder circuit board 220 is manufactured by layering, attaching by pressure, and firing ceramic sheets made of a dielectric material or a magnetic material. The feeder terminal electrodes 201a and 201b and mounting electrodes 201c and 201d are formed on a top-layer sheet 231a. Connection electrodes 203a and 203b are formed on a second-layer sheet 231b. Wiring electrodes 204a and 204b composing the inductance elements L1 and L2, respectively, are formed on the sheets from a third-layer sheet 231c to a seventh-layer sheet 231g.

Layering the above sheets 231a to 231g forms the inductance element L1 in which the wiring electrodes 204a are helically connected to each other via a via-hole conductor 205a and forms the inductance element L2 in which the wiring electrodes 204b are helically connected to each other via a via-hole conductor 205b. One end of the inductance element L1 (the wiring electrode 204a) is conductively connected to one end of the inductance element L2 (the wiring electrode 204b) on the sheet 231c, and the other end of the inductance element L1 and the other end of the inductance element L2 are connected to the feeder terminal electrodes 201a and 201b, respectively, via the connection electrodes 203a and 203b and via-hole conductors 206a and 206b.

The feeder circuit 200 having the above structure has the same operation and effect as those described in the first and second embodiments. Particularly, in the feeder circuit 200 shown in Fig. 30, one end of the inductance element L1 is conductively connected to one end of the inductance element L2 near the top layer in the multilayer body, and the other end of the inductance element L1 and the other end of the inductance element L2 are connected to the wireless IC chip 10. Specifically, the inductance element L1 is conductively connected to the inductance element L2 near the top layer in the multilayer body, which is away from the radiation strip 212, and the inductance elements L1 and L2 are wound in opposite directions near the bottom layer in the multilayer body, which is electromagnetically coupled to the radiation strip 212, so that the efficiency of energy transfer is improved.

In the radiation substrate 210, as shown in Fig. 31, the radiation strip 212 having one end 212a and the other end 212b is helically formed on the front face of the flexible resin film base 211 and an electrode 213 adjacent to the end 212a is formed. The electrode 213 is electrically conducted to the other end 212b of the radiation strip 212 via a connection electrode 214 formed on the rear face of the base 211 and a via-hole conductor. The feeder circuit board 220 on which the wireless IC chip 10 is mounted is coupled to the end 212a of the radiation strip 212 and an end 213a of the electrode 213.

The end 212a of the radiation strip 212 and the end 213a of the electrode 213 may have planer shapes, as shown in Fig. 31(B), or may be helically formed, as shown in Fig. 31(C). The case where the end 212a of the radiation strip 212 and the end 213a of the electrode 213 are helically formed corresponds to the fourteenth and fifteenth embodiments.

### (Summery of Embodiments)

The at least two inductance elements may be formed at different positions in a perspective plan view of the feeder circuit in the wireless IC devices described above. For example, the feeder circuit can be coupled to two different radiation strips. Alternatively, the at least two inductance elements may be formed of two wiring electrodes adjacent to each other on the same plane. When one inductance element is composed of two adjacent wiring electrodes, the length of the wiring electrodes or the distance between the wiring electrodes can be varied to broaden the resonance characteristics.

The feeder circuit board may be formed of a multilayer body, and the planer electrodes having outer dimensions that are the same as or smaller than those of the at least two inductance elements may be provided inside or on the front face of the bottom layer of the multilayer body in a perspective plan view of the feeder circuit board. The provision of the planer electrodes allows a variation in coupling between the feeder circuit and the radiation strip to be suppressed.

The feeder circuit board may include a magnetic body and the at least two inductance elements may be formed inside the magnetic body. The inclusion of the magnetic body in the feeder circuit board achieves a higher inductance and allows frequencies around 13.56-MHz band to be supported.

Of the at least two inductance elements, one end of a inductance element may be conductively connected to one end of the other inductance element near the top layer in the multilayer body and the other ends of the inductance elements may be coupled to the wireless IC. Specifically, the two inductance elements are conductively connected to each other near the top layer in the multilayer body, which is away from the radiation strip, and are wound in opposite directions near the bottom layer in the multilayer body, which is electromagnetically coupled to the radiation strip, so that the efficiency of energy transfer is improved.

The radiation strip may be composed of a loop electrode having one end and the other end. In this case, the one end and the other end may be coupled to the at least two different inductance elements and may be helically formed with being wound in opposite directions. Since the direction of the magnetic field generated at the side of the radiation strip can be the same direction as that of the magnetic field generated in the feeder circuit, the degree of coupling between the feeder circuit and the radiation strip is increased. It is preferred that the inductance element and the helical end of the radiation strip, which are formed so as to be coupled to each other, be formed so as to be wound in the same direction in a perspective plan view of the feeder circuit. In this case, the magnetic fields of the same direction are generated in the two helical electrodes arranged so as to be opposed to each other in the perspective plan view, so that the magnetic-field coupling between the feeder circuit and the radiation strip is further increased. Furthermore, it is preferred that the inductances of the loop electrodes be higher than those of the inductance elements in the feeder circuit. Since signals generated in the feeder circuit can be transmitted and received with the magnetic field generated around the radiation strip, it is possible to suppress an occurrence of communication failure with a reader-writer.

The magnetic body may be arranged inside or on the front face of the loop of the loop electrodes. In this case, the magnetic field generated around the radiation strip composed of the loop electrode is amplified, thus increasing the communication distance.

The at least two inductance elements may be connected in series to the wireless IC, may be connected in parallel to the wireless IC, or may have substantially the same inductance.

Multiple mounting electrodes for mounting the wireless IC may be formed on the main face of the feeder circuit board and the at least two mounting electrodes may be electrically conducted to each other via the feeder circuit. The at least two mounting electrodes may be balanced input-output terminal electrodes. The feeder circuit may include an auxiliary matching circuit in which one end may be electrically connected to a predetermined position in the feeder circuit and the other end is electrically opened. The auxiliary matching circuit enables fine adjustment of the matching state. In addition, the at least two mounting electrodes may be balanced input-output terminal electrodes.

Part of the at least two inductance elements may be bare along the side faces of the feeder circuit board and the part that is exposed to the outside may be structured so as to also function as the radiation strip. In this case, the part of the inductance elements is electromagnetically coupled to the radiation strip on the side faces of the feeder circuit board to improve the radiation characteristics.

The feeder circuit board may be a multilayer board made of ceramics or resin or may be a flexible board. Particularly, incorporating the inductance elements composing the feeder circuit in the board causes the feeder circuit to be less susceptible to the outside of the board, thereby suppressing a variation in the radiation characteristics.

The at least two inductance elements may be conductively connected in series to each other. In this case, it is possible to reliably generate the magnetic fields of different directions in the inductance elements.

### (Other Embodiments)

The wireless IC device according to the present invention is not restricted to the above embodiments and various modifications may occur insofar as they are within the scope of the present invention.

For example, the wireless IC may not be of a chip type and may be integrated with the feeder circuit board. The radiation strip may adopt various shapes.

### Industrial Applicability

As described above, the present invention is useful for a wireless IC device. Particularly, the wireless IC device of the present invention is excellent in that the wireless IC device is less susceptible to, for example, the environment in which the wireless IC device is used, is capable of suppressing a variation in the radiation characteristics, and is capable of being used in a wideband.

## Claims

1. A wireless IC device comprising:
an IC (10);
a feeder circuit board (20; 220) provided with a feeder circuit (21; 150; 200) that is coupled to the IC (10) and that includes a resonant circuit and/or a matching circuit including at least two inductance elements (L1. L2); and
a radiation strip (23; 52; 132; 212) on which the feeder circuit board (20; 220) is adhered or to which the feeder circuit board (20; 220) is arranged in proximity and which radiates a transmission signal supplied from the feeder circuit (21; 150; 200) and/or supplies a received signal to the feeder circuit (21; 150; 2,00),
wherein the at least two inductance elements (L1, L2) are helically formed with being wound in opposite directions.

2. The wireless IC device according to Claim 1,
wherein the resonant frequencies of the transmission signal and/or the reception signal substantially correspond to the self-resonant frequency of the resonant circuit.

3. The wireless IC device according to any of Claims 1 or 2,
wherein the at least two inductance elements (L1, L2) are formed at different positions in a perspective plan view of the feeder circuit (21; 150; 200).

4. The wireless IC device according to any of Claims 1 to 3,
wherein the at least two inductance elements (L1, L2) are formed of two wiring electrodes (46a, 46b; 66a to 66d; 75a, 75b; 85a, 85b; 101a, 101b; 111a, 111b; 125a, 125b; 204a, 204b) adjacent to each other on the same plane.

5. The wireless IC device according to any of Claims 1 to 4.
wherein the feeder circuit board (20; 220) is formed of a multilayer body, and planar electrodes (49a, 49b; 88a, 88b; 112a, 112b; 128a, 128b) having outer dimensions that are the same as or smaller than those of the at least two inductance elements (L1, L2) are provided inside or on the front face of the bottom layer of the multilayer body in a perspective plan view of the feeder circuit board.

6. The wireless IC device according to any of Claims 1 to 5,
wherein the feeder circuit board (20; 220) includes a magnetic body, and the at least two inductance elements (L1, L2) are formed inside and/or on the front face of the magnetic body.

7. The wireless IC device according to any of Claims 1 to 6,
wherein one ends of the at least two inductance elements (L1, L2) are conductively connected to each other near the top layer of a multilayer body and the other ends thereof are coupled to the IC (10).

8. The wireless IC device according to any of Claims 1 to 7,
wherein the radiation strip (212) is composed of a loop electrode having one end and the other end, and the one end (L11) and the other end (L12) are coupled to the at least two different inductance elements (L1, L2) and are helically formed with being wound in opposite directions.

9. The wireless IC device according to Claim 8,
wherein the respective one of the inductance elements (L1, L2) and the respective one of the helical ends (L11, L12) of the radiation strip (212), which are coupled to each other, are formed so as to be wound in the same direction in a perspective plan view of the feeder circuit (200).

10. The wireless IC device according to Claim 8 or 9,
wherein the inductance of the loop electrode is higher than those of the inductance elements (L1, L2) in the feeder circuit (200).

11. The wireless IC device according to any of Claims 8 to 10,
wherein a magnetic body (33) is arranged inside or on the front face of the loop of the loop electrode.

12. The wireless IC device according to any of Claims 1 to 11,
wherein the at least two inductance elements (L1, L2) have substantially the same inductance.

13. The wireless IC device according to any of Claims 1 to 12,
wherein multiple mounting electrodes (43a, 43b; 63a, 63b; 73a, 73b; 83a, 83b; 123a, 123b) for mounting the IC (10) are formed on the main face of the feeder circuit board (20; 220) and at least two mounting electrodes are electrically connected to each other via the feeder circuit (21; 150; 200).

14. The wireless 1C device according to Claim 13,
wherein the at least two mounting electrodes (43a, 43b; 63a, 63b; 73a, 73b; 83a, 83b; 123a, 123b) are balanced input-output terminal electrodes.

15. The wireless IC device according to any of Claims 1 to 14,
wherein the feeder circuit (21; 150; 200) includes an auxiliary matching circuit (129) in which one end is electrically connected to a predetermined position in the feeder circuit (21; 150; 200) and the other end is electrically opened.

16. The wireless IC device according to any of Claims 1 to 15,
wherein part of the at least two inductance elements (L1, L2) is bare along the side faces of the feeder circuit board (20; 220) and the part that is exposed to the outside also functions as a radiation strip (23; 52; 132; 212).

17. The wireless IC device according to any of Claims 1 to 16,
wherein the at least two inductance elements (L1, L2) are conductively connected in series to each other.

## Patentansprüche

1. Eine drahtlose IC-Vorrichtung, die folgende Merkmale aufweist:
eine IC (10);
eine Speiseschaltungsplatine (20; 220), die mit einer Speiseschaltung (21; 150; 200) versehen ist, die mit der IC (10) gekoppelt ist und die eine Resonanzschaltung und/oder eine Anpassungsschaltung umfasst, die zumindest zwei Induktanzelemente (L1. L2) umfasst; und
einen Strahlungsstreifen (23; 52; 132; 212), an dem die Speiseschaltungsplatine (20; 220) haftet oder in dessen Nähe die Speiseschaltungsplatine (20; 220) angeordnet ist und der ein von der Speiseschaltung (21; 150; 200) geliefertes Sendesignal ausstrahlt und/oder ein empfangenes Signal an die Speiseschaltung (21; 150; 200) liefert,
wobei die zumindest zwei Induktanzelemente (L1, L2) spiralförmig gebildet sind und dabei in entgegengesetzten Richtungen gewickelt sind.

2. Die drahtlose IC-Vorrichtung gemäß Anspruch 1,
bei der die Resonanzfrequenzen des Sendesignals und/oder des Empfangssignals im Wesentlichen der Eigenresonanzfrequenz der Resonanzschaltung entsprechen.

3. Die drahtlose IC-Vorrichtung gemäß einem der Ansprüche 1 oder 2,
bei der die zumindest zwei Induktanzelemente (L1, L2) an unterschiedlichen Positionen in einer perspektivischen Draufsicht der Speiseschaltung (21; 150; 200) gebildet sind.

4. Die drahtlose IC-Vorrichtung gemäß einem der Ansprüche 1 bis 3,
bei der die zumindest zwei Induktanzelemente (L1, L2) aus zwei Verdrahtungselektroden (46a, 46b; 66a bis 66d; 75a, 75b; 85a, 85b; 101a, 101b; 111a, 111b; 125a, 125b; 204a, 204b) gebildet sind, die in derselben Ebene nebeneinander liegen.

5. Die drahtlose IC-Vorrichtung gemäß einem der Ansprüche 1 bis 4,
bei der die Speiseschaltungsplatine (20; 220) aus einem Mehrschichtkörper gebildet ist und Planarelektroden (49a, 49b; 88a, 88b; 112a, 112b; 128a, 128b), die Außenabmessungen aufweisen, die gleich denen der zumindest zwei Induktanzelemente (L1, L2) oder kleiner als diese sind, in einer perspektivischen Draufsicht auf die Speiseschaltungsplatine im Inneren oder auf der Vorderseite der unteren Schicht des Mehrschichtkörpers vorgesehen sind.

6. Die drahtlose IC-Vorrichtung gemäß einem der Ansprüche 1 bis 5,
bei der die Speiseschaltungsplatine (20; 220) einen magnetischen Körper umfasst und die zumindest zwei Induktanzelemente (L1, L2) im Inneren und/oder auf der Vorderseite des magnetischen Körpers gebildet sind.

7. Die drahtlose IC-Vorrichtung gemäß einem der Ansprüche 1 bis 6,
bei der jeweils ein Ende der zumindest zwei Induktanzelemente (L1, L2) in der Nähe der oberen Schicht eines Mehrschichtkörpers leitfähig miteinander verbunden sind und die anderen Enden derselben mit der IC (10) gekoppelt sind.

8. Die drahtlose IC-Vorrichtung gemäß einem der Ansprüche 1 bis 7,
bei der der Strahlungsstreifen (212) aus einer Schlingenelektrode gebildet ist, die ein Ende und das andere Ende aufweist, und das eine Ende (L 11) und das andere Ende (L12) mit den zumindest zwei verschiedenen Induktanzelementen (L1, L2) gekoppelt sind und spiralförmig gebildet sind, wobei sie in entgegengesetzten Richtungen gewickelt sind.

9. Die drahtlose IC-Vorrichtung gemäß Anspruch 8,
bei der das jeweilige der Induktanzelemente (L1, L2) und das jeweilige der spiralförmigen Enden (L11, L12) des Strahlungsstreifens (212), die miteinander gekoppelt sind, dahingehend gebildet sind, in einer perspektivischen Draufsicht auf die Speiseschaltung (200) in derselben Richtung gewickelt zu sein.

10. Die drahtlose IC-Vorrichtung gemäß Anspruch 8 oder 9,
bei der die Induktanz der Schlingenelektrode höher ist als diejenigen der Induktanzelemente (L1, L2) bei der Speiseschaltung (200).

11. Die drahtlose IC-Vorrichtung gemäß einem der Ansprüche 8 bis 10,
bei der ein magnetischer Körper (33) im Inneren oder auf der Vorderseite der Schlinge der Schlingenelektrode angeordnet ist.

12. Die drahtlose IC-Vorrichtung gemäß einem der Ansprüche 1 bis 11,
bei der die zumindest zwei Induktanzelemente (L1, L2) im Wesentlichen dieselbe Induktanz aufweisen.

13. Die drahtlose IC-Vorrichtung gemäß einem der Ansprüche 1 bis 12,
bei der mehrere Anbringelektroden (43a, 43b; 63a, 63b; 73a, 73b; 83a, 83b; 123a, 123b) zum Anbringen der IC (10) auf der Hauptseite der Speiseschaltungsplatine (20; 220) gebildet sind und zumindest zwei Anbringelektroden über die Speiseschaltung (21; 150; 200) elektrisch miteinander verbunden sind.

14. Die drahtlose IC-Vorrichtung gemäß Anspruch 13,
bei der die zumindest zwei Anbringelektroden (43a, 43b; 63a, 63b; 73a, 73b; 83a, 83b; 123a, 123b) symmetrische Eingangs-/Ausgangsanschlusselektroden sind.

15. Die drahtlose IC-Vorrichtung gemäß einem der Ansprüche 1 bis 14,
bei der die Speiseschaltung (21; 150; 200) eine Hilfsanpassungsschaltung (129) umfasst, bei der ein Ende mit einer vorbestimmten Position in der Speiseschaltung (21; 150; 200) elektrisch verbunden ist und das andere Ende elektrisch geöffnet ist.

16. Die drahtlose IC-Vorrichtung gemäß einem der Ansprüche 1 bis 15,
bei der ein Teil der zumindest zwei Induktanzelemente (L1, L2) entlang der Seitenflächen der Speiseschaltungsplatine (20; 220) blank ist und der Teil, der nach außen hin freiliegend ist, auch als Strahlungsstreifen (23; 52; 132; 212) fungiert.

17. Die drahtlose IC-Vorrichtung gemäß einem der Ansprüche 1 bis 16,
bei der die zumindest zwei Induktanzelemente (L1, L2) auf leitfähige Weise miteinander in Reihe geschaltet sind.

## Revendications

1. Dispositif CI sans fil comprenant :
un CI (10);
une carte de circuit d'alimentation (20 ; 220) pourvue d'un circuit d'alimentation (21 ; 150 ; 200) qui est couplé au CI (10) et qui comprend un circuit résonant et/ou un circuit d'adaptation comprenant au moins deux éléments d'inductance (L1, L2) ; et
une bande de rayonnement (23 ; 52 ; 132 ; 212) sur laquelle est collée la carte de circuit d'alimentation (20 ; 220) ou à proximité de laquelle est disposée la carte de circuit d'alimentation (20 ; 220) et qui rayonne un signal de transmission envoyé par le circuit d'alimentation (21 ; 150 ; 200) et/ou envoie un signal reçu au circuit d'alimentation (21 ; 150 ; 200),
les au moins deux éléments d'inductance (L1, L2) étant enroulés en hélice, dans des sens opposés.

2. Dispositif CI sans fil selon la revendication 1,
dans lequel les fréquences de résonance du signal de transmission et/ou du signal de réception correspondent essentiellement à la fréquence de résonance propre du circuit résonant.

3. Dispositif CI sans fil selon l'une quelconque des revendications 1 ou 2,
dans lequel les au moins deux éléments d'inductance (L1, L2) sont formés à des positions différentes, sur une vue de dessus en perspective du circuit d'alimentation (21 ; 150 ; 200).

4. Dispositif CI sans fil selon l'une quelconque des revendications 1 à 3,
dans lequel les au moins deux éléments d'inductance (L1, L2) sont formés de deux électrodes de câblage (46a, 46b ; 66a à 66d ; 75a, 75b ; 85a, 85b ; 101 a, 101b ; 111a, 111b ; 125a, 125b ; 204a, 204b) disposées côte-à-côte sur le même plan.

5. Dispositif CI sans fil selon l'une quelconque des revendications 1 à 4,
dans lequel la carte de circuit d'alimentation (20 ; 220) est formée d'un corps multicouche, et des électrodes planes (49a, 49b ; 88a, 88b ; 112a, 112b ; 128a, 128b) ayant des dimensions extérieures qui sont identiques ou inférieures à celles des au moins deux éléments d'inductance (L1, L2) sont prévues à l'intérieur ou sur la face avant de la couche inférieure du corps multicouche, sur une vue de dessus en perspective de la carte de circuit d'alimentation.

6. Dispositif CI sans fil selon l'une quelconque des revendications 1 à 5,
dans lequel la carte de circuit d'alimentation (20 ; 220) comprend un corps magnétique, et les au moins deux éléments d'inductance (L1, L2) sont formés à l'intérieur et/ou sur la face avant du corps magnétique.

7. Dispositif CI sans fil selon l'une quelconque des revendications 1 à 6,
dans lequel des premières extrémités des au moins deux éléments d'inductance (L1, L2) sont connectées l'une à l'autre de façon conductrice à proximité de la couche supérieure d'un corps multicouche, et leurs autres extrémités sont couplées au CI (10).

8. Dispositif CI sans fil selon l'une quelconque des revendications 1 à 7,
dans lequel la bande de rayonnement (212) est constituée d'une électrode en boucle ayant une extrémité et une autre extrémité, l'extrémité (L11) et l'autre extrémité (L12) étant couplées aux au moins deux éléments d'inductance différents (L1, L2) et étant enroulés en hélice, dans des sens opposés.

9. Dispositif CI sans fil selon la revendication 8,
dans lequel chacun des éléments d'inductance (L1, L2) et chacune des extrémités en hélice correspondantes (L11, L12) de la bande de rayonnement (212), qui sont couplés entre eux, sont formés de façon à être enroulés dans le même sens, sur une vue de dessus en perspective du circuit d'alimentation (200).

10. Dispositif CI sans fil selon la revendication 8 ou 9,
dans lequel l'inductance de l'électrode en boucle est supérieure à celle des éléments d'inductance (L1, L2) dans le circuit d'alimentation (200).

11. Dispositif CI sans fil selon l'une quelconque des revendications 8 à 10,
dans lequel un corps magnétique (33) est disposé à l'intérieur ou sur la face avant de la boucle de l'électrode en boucle.

12. Dispositif CI sans fil selon l'une quelconque des revendications 1 à 11,
dans lequel les au moins deux éléments d'inductance (L1, L2) ont essentiellement la même inductance.

13. Dispositif CI sans fil selon l'une quelconque des revendications 1 à 12,
dans lequel plusieurs électrodes de montage (43a, 43b ; 63a, 63b ; 73a, 73b ; 83a, 83b ; 123a, 123b) pour le montage du CI (10) sont formées sur la face principale de la carte de circuit d'alimentation (20 ; 220) et au moins deux électrodes de montage sont reliées électriquement l'une à l'autre via le circuit d'alimentation (21 ; 150 ; 200).

14. Dispositif CI sans fil selon la revendication 13,
dans lequel les au moins deux électrodes de montage (43a, 43b ; 63a, 63b ; 73a, 73b ; 83a, 83b ; 123a, 123b) sont des électrodes formant bornes d'entrée-sortie équilibrées.

15. Dispositif CI sans fil selon l'une quelconque des revendications 1 à 14,
dans lequel le circuit d'alimentation (21 ; 150 ; 200) comprend un circuit d'adaptation auxiliaire (129) dans lequel une extrémité est connectée électriquement à une position prédéterminée sur le circuit d'alimentation (21 ; 150 ; 200) et l'autre extrémité est électriquement ouverte.

16. Dispositif CI sans fil selon l'une quelconque des revendications 1 à 15,
dans lequel une partie des au moins deux éléments d'inductance (L1, L2) est nue le long des faces latérales de la carte de circuit d'alimentation (20 ; 220) et la partie qui est exposée à l'extérieur joue également le rôle de bande de rayonnement (23 ; 52 ; 132 ; 212).

17. Dispositif CI sans fil selon l'une quelconque des revendications 1 à 16,
dans lequel les au moins deux éléments d'inductance (L1, L2) sont connectés en série l'un à l'autre de façon conductrice.
